# EUROPEAN PATENT SPECIFICATION

(11) **EP 4 531 081 B1**
(45) Date of publication and mention of the grant of the patent: **28.10.2026**
(21) Application number: 24203323.1
(22) Date of filing: 27.09.2024
(51) Int. Cl.: H10P 72/00

(54) **STANDARD BASE COMPONENTS FOR FORMING INBOARD AND OUTBOARD SUBSTRATE HANDLING CHAMBERS AND THEIR USE IN PRODUCTION OF SUBSTRATE PROCESSING SYSTEMS WITH EXPANDED PRODUCTION CAPACITY**
STANDARDBASISKOMPONENTEN ZUR BILDUNG VON INNEN- UND AUSSENBORDSUBSTRATHANDHABUNGSKAMMERN UND IHRE VERWENDUNG BEI DER HERSTELLUNG VON SUBSTRATVERARBEITUNGSSYSTEMEN MIT ERWEITERTER PRODUKTIONSKAPAZITÄT
COMPOSANTS DE BASE STANDARD POUR FORMER DES CHAMBRES DE MANIPULATION DE SUBSTRAT INTÉRIEURE ET EXTÉRIEURE ET LEUR UTILISATION DANS LA PRODUCTION DE SYSTÈMES DE TRAITEMENT DE SUBSTRAT À CAPACITÉ DE PRODUCTION ÉTENDUE

(30) Priority: 28.09.2023 US 202363586140 P
(43) Date of publication of application: 02.04.2025
(73) Proprietor: ASM IP Holding B.V., 1322 AP Almere (NL)
(72) Inventor: SUBAS CHANDRA BOSE, Senthil Arasu, 1322 AP Almere (NL)
(74) Representative: V.O.

(56) References cited:
- US-A1- 2014 271 055
- US-A1- 2021 111 051
- US-A1- 2023 022 174
- US-B1- 6 216 328

## Description

### FIELD OF THE DISCLOSURE

The present disclosure relates generally to substrate processing systems having expanded substrate processing capabilities. Some more particular aspects of this technology relate to substrate handling chamber precursors that can be used to make two (or more) different styles of substrate handling chamber bodies. Still additional aspects of this technology relate to methods of making substrate handling chamber bodies of different styles and for different areas of a substrate processing system using a standard substrate handling chamber precursor.

### BACKGROUND OF THE DISCLOSURE

Material layers are commonly deposited onto substrates during fabrication of semiconductor devices, such as during fabrication of integrated circuits and electronic devices. Material layer deposition generally is accomplished by supporting a substrate within a substrate processing chamber arrangement, heating the substrate to a desired deposition temperature, and flowing one or more material layer precursor gases through the chamber arrangement and across the substrate. As the precursor gas flows across the substrate, the material layer progressively develops onto the surface of the substrate, typically according to the temperature of the substrate and environmental conditions within the chamber arrangement. US 2021/0111051 A discloses a chamber structure including an internal space in which a transfer robot is installed. The chamber structure is connected to a processing apparatus that is used for manufacturing semiconductor substrates. The known chamber structure includes a multi-faceted body. A projection designed as a separate part is bolted to the multi-faceted body. US6216328B1 discloses that a substrate chamber housing is machined from a rolled forging, which advantageously increases the manufacturing efficiency of said chamber housing.

In a cluster type semiconductor vacuum processing tool, multiple substrate processing chambers may be coupled with a single substrate handling chamber that moves substrates into and out of the substrate processing chambers and into and out of the overall substrate processing system. Such systems allow multiple substrates to be processed simultaneously using some common equipment.

Conventional semiconductor production systems and methods generally have been acceptable for their intended purpose, but there is room for improvement. For example, additional ways of improving production efficiency, increasing throughput, reducing costs, and/or simplifying production processes would be welcome advances in the art.

### SUMMARY OF THE DISCLOSURE

Aspects of this technology relate to substrate processing systems and methods having expanded substrate processing capabilities. Some more particular aspects of this technology relate to substrate handling chamber precursors that can be used to make two (or more) different styles of substrate handling chamber bodies. Additional aspects of this technology relate to methods of making substrate handling chamber bodies of different styles and for different areas of a substrate processing system using a standard substrate handling chamber precursor.

Substrate handling chamber precursors in accordance with at least some examples of this technology include one or more of: (a) a main body portion including a first major surface, a second major surface opposite the first major surface, and multiple facets forming sidewalls extending between the first major surface and the second major surface; (b) a projection extending from the second major surface and in a direction away from the first major surface, wherein the main body portion and the projection are formed as a single, one-piece, forged component part; (c) a first recess extending inward from the first major surface, the first recess including a bottom surface; and/or (d) a through hole opening extending from the bottom surface of the first recess through the projection. The substrate handling chamber precursor requires machining to form therefrom a substrate handling chamber, wherein the substrate handling chamber precursor is configured to be machined so as to form therefrom substrate handling chambers of at least two different types.

In addition to one or more of the features described above, or as an alternative, in at least some examples of this technology, the projection will comprise a round cylindrical structure extending from the second major surface.

In addition to one or more of the features described above, or as an alternative, in at least some examples of this technology, the first recess will define a circular perimeter having a first diameter and the through hole opening will define a circular perimeter having a second diameter, wherein the second diameter is less than one half the first diameter.

In addition to one or more of the features described above, or as an alternative, in at least some examples of this technology, the multiple facets forming the sidewalls of the main body portion will form a hexagonal shape.

In addition to one or more of the features described above, or as an alternative, in at least some examples of this technology, the multiple facets will include: (a) a first facet, (b) a second facet extending from the first facet at a first angle, (c) a third facet extending from the first facet at a second angle, (d) a fourth facet extending from the second facet at a third angle, (e) a fifth facet extending from the third facet at a fourth angle, and (f) a sixth facet extending between the fourth facet and the fifth facet.

In addition to one or more of the features described above, or as an alternative, in at least some examples of this technology, the second angle will be substantially equal to the first angle and/or the third angle will be substantially equal to the fourth angle.

In addition to one or more of the features described above, or as an alternative, in at least some examples of this technology, the third angle will be at least 30 degrees larger than the first angle.

In addition to one or more of the features described above, or as an alternative, in at least some examples of this technology, the sixth facet will extend from the fourth facet at a fifth angle and the sixth facet will extend from the fifth facet at a sixth angle, wherein the fifth angle is substantially equal to the sixth angle.

In addition to one or more of the features described above, or as an alternative, in at least some examples of this technology, the third angle will be at least 30 degrees larger than the first angle and/or at least 30 degrees larger than the fifth angle.

In addition to one or more of the features described above, or as an alternative, in at least some examples of this technology, each of the first facet and the sixth facet will be wider than each of the second facet, the third facet, the fourth facet, and the fifth facet.

In addition to one or more of the features described above, or as an alternative, in at least some examples of this technology, each of the first facet, the second facet, the third facet, and the sixth facet will at least 1.3 times wider than each of the fourth facet and the fifth facet.

Methods of manufacturing substrate handling chambers in accordance with at least some examples of this technology may comprise one or more of: (a) providing a first substrate handling chamber precursor and a second substrate handling chamber precursor, the first substrate handling chamber precursor having a first set of dimensions and the second substrate handling chamber precursor having a second set of dimensions that are substantially equal to corresponding dimensions of the first set of dimensions such that the first substrate handling chamber precursor and the second substrate handling chamber precursor are substantially equivalent in size and shape; (b) machining the first substrate handling chamber precursor to remove a first amount of material from the first substrate handling chamber precursor to form a first substrate handling chamber body, wherein the first substrate handling chamber body includes a first exterior perimeter shape having a first number of facets located around and forming first sidewalls of the first substrate handling chamber body; and (c) machining the second substrate handling chamber precursor to remove a second amount of material from the second substrate handling chamber precursor to form a second substrate handling chamber body, wherein the second substrate handling chamber body includes a second exterior perimeter shape having a second number of facets located around and forming second sidewalls of the second substrate handling chamber body, wherein the second number of facets is less than the first number of facets, and wherein the second amount of material is greater than the first amount of material.

In addition to one or more of the features described above, or as an alternative, in at least some examples of this technology, each of the first substrate handling chamber precursor and the second substrate handling chamber precursor will have a main body portion including a first major surface, a second major surface opposite the first major surface, and multiple facets forming sidewalls extending between the first major surface and the second major surface.

In addition to one or more of the features described above, or as an alternative, in at least some examples of this technology, each of the first substrate handling chamber precursor and the second substrate handling chamber precursor further may include a projection extending from the second major surface and in a direction away from the first major surface, wherein the main body portion and the projection are formed as a single, one-piece, forged component part.

In addition to one or more of the features described above, or as an alternative, in at least some examples of this technology, each of the first substrate handling chamber precursor and the second substrate handling chamber precursor further may include a first recess extending inward from the first major surface, the first recess including a bottom surface.

In addition to one or more of the features described above, or as an alternative, in at least some examples of this technology, each of the first substrate handling chamber precursor and the second substrate handling chamber precursor further may include a through hole opening extending from the bottom surface of the first recess through the projection.

In addition to one or more of the features described above, or as an alternative, in at least some examples of this technology, the first recess will define a circular perimeter having a first diameter and the through hole opening will define a circular perimeter having a second diameter, wherein the second diameter is less than one half the first diameter.

In addition to one or more of the features described above, or as an alternative, in at least some examples of this technology, the projection of each of the first substrate handling chamber precursor and the second substrate handling chamber precursor comprises a round cylindrical structure extending from the second major surface.

In addition to one or more of the features described above, or as an alternative, in at least some examples of this technology, the first number of facets forming the first sidewalls of the first substrate handling chamber body comprises at least six facets, and/or the second number of facets forming the second sidewalls of the second substrate handling chamber body comprises no more than five facets.

In addition to one or more of the features described above, or as an alternative, in at least some examples of this technology, each of the first substrate handling chamber precursor and the second substrate handling chamber precursor includes: (a) a first facet, (b) a second facet extending from the first facet at a first angle, (c) a third facet extending from the first facet at a second angle, (d) a fourth facet extending from the second facet at a third angle, (e) a fifth facet extending from the third facet at a fourth angle, and (f) a sixth facet extending between the fourth facet and the fifth facet.

In addition to one or more of the features described above, or as an alternative, in at least some examples of this technology, the second angle will be substantially equal to the first angle and/or the third angle will be substantially equal to the fourth angle.

In addition to one or more of the features described above, or as an alternative, in at least some examples of this technology, the sixth facet will extend from the fourth facet at a fifth angle and/or the sixth facet will extend from the fifth facet at a sixth angle, wherein the fifth angle is substantially equal to the sixth angle.

In addition to one or more of the features described above, or as an alternative, in at least some examples of this technology, the third angle will be at least 30 degrees larger than the first angle and/or at least 30 degrees larger than the fifth angle.

In addition to one or more of the features described above, or as an alternative, in at least some examples of this technology, each of the first facet and the sixth facet will be wider than each of the second facet, the third facet, the fourth facet, and the fifth facet.

In addition to one or more of the features described above, or as an alternative, in at least some examples of this technology, each of the first facet, the second facet, the third facet, and the sixth facet will be at least 1.3 times wider than each of the fourth facet and the fifth facet.

In addition to one or more of the features described above, or as an alternative, in at least some examples of this technology, the first substrate handling chamber precursor and the second substrate handling chamber precursor are provided as part of an inventory of precursors provided for forming multiple substrate handling chamber bodies, wherein each precursor of the inventory includes a set of dimensions that are substantially equal to corresponding dimensions of the first set of dimensions such that all precursors in the inventory have substantially equivalent sizes and shapes.

In addition to one or more of the features described above, or as an alternative, in at least some examples of this technology: (i) the first substrate handling chamber body is formed to include: (a) a first top surface, (b) a first bottom surface located opposite the first top surface, and (c) a first chamber extending inward from the first top surface, and wherein the method further comprises: engaging a first lid with the first substrate handling chamber body, wherein the first lid is sized, shaped, and movably positionable to cover a first opening to the first chamber at the first top surface; and/or (ii) the second substrate handling chamber body is formed to include: (a) a second top surface, (b) a second bottom surface located opposite the second top surface, and (c) a second chamber extending inward from the second top surface, and wherein the method further comprises: engaging a second lid with the second substrate handling chamber body, wherein the second lid is sized, shaped, and movably positionable to cover a second opening to the second chamber at the second top surface.

In addition to one or more of the features described above, or as an alternative, in at least some examples of this technology: (i) the first substrate handling chamber body is formed to include: (a) a first top surface, (b) a first bottom surface located opposite the first top surface, (c) a first chamber extending inward from the first top surface to a first interior bottom face, and (d) a first through hole opening extending from the first interior bottom face to the first bottom surface, and wherein the method further comprises: placing a first substrate transfer robot in the first chamber such that a first portion of the first substrate transfer robot extends into the first through hole opening below the first interior bottom face; and/or (ii) the second substrate handling chamber body is formed to include: (a) a second top surface, (b) a second bottom surface located opposite the second top surface, (c) a second chamber extending inward from the second top surface to a second interior bottom face, and (d) a second through hole opening extending from the second interior bottom face to the second bottom surface, and wherein the method further comprises: placing a second substrate transfer robot in the second chamber such that a second portion of the second substrate transfer robot extends into the second through hole opening below the second interior bottom face.

This summary is provided to introduce a selection of concepts relating to this technology in a simplified form. These concepts are described in further detail in the detailed description of examples of the disclosure below. This summary is not intended to identify key features or essential features of the claimed subject matter, nor is it intended to be used to limit the scope of the claimed subject matter.

### BRIEF DESCRIPTION OF THE DRAWING FIGURES

These and other features, aspects, and advantages of the invention disclosed herein are described below with reference to the drawings of certain embodiments, which are intended to illustrate and not to limit the invention.
Fig. 1 is a schematic view of an extended, cluster type substrate processing system that may incorporate and/or use aspects of this technology;
Figs. 2A-2D provide various views of a substrate handling chamber precursor in accordance with some examples of this technology;
Figs. 3A-3C provide various views illustrating features and use of standard substrate processing chamber precursors in accordance with some examples of this technology; and
Figs. 4A-4C show various features of structures, methods, and assembly of substrate handling chambers in accordance with some examples of this technology.

It will be appreciated that elements in the figures are illustrated for simplicity and clarity and have not necessarily been drawn to scale. For example, the relative size of some of the elements in the figures may be exaggerated relative to other elements to help improve understanding of illustrated embodiments of the present disclosure.

### DETAILED DESCRIPTION

Reference now will be made to the drawings wherein like reference numerals identify similar structural features or aspects of the subject disclosure.

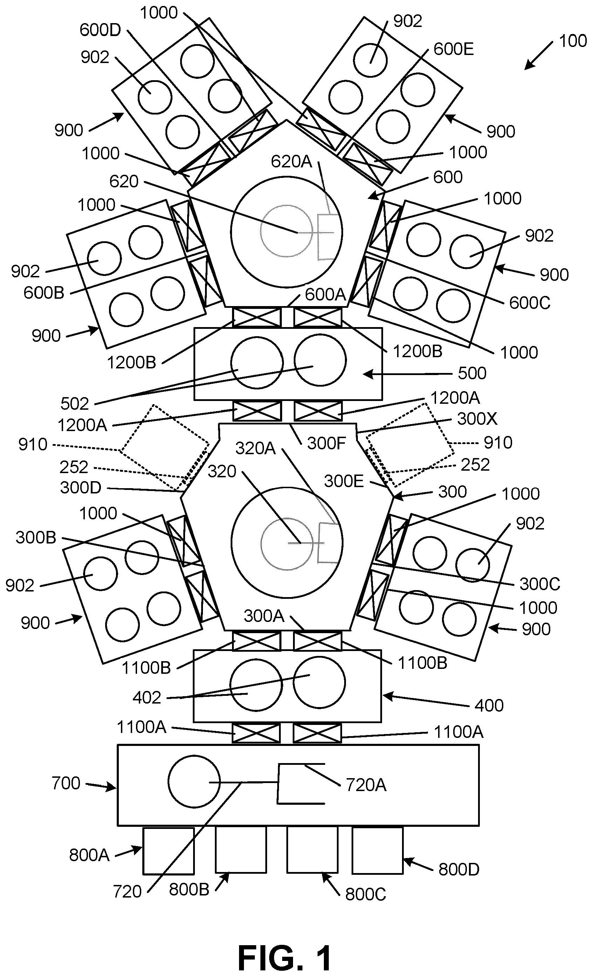

Fig. 1 schematically illustrates an overhead view of a substrate processing system 100 (e.g., a cluster type semiconductor processing system) having expanded substrate processing capabilities in accordance with some examples of this technology. This substrate processing system 100 expands substrate processing capabilities at least by adding an additional substrate handling chamber and one or more additional substrate processing chambers as compared to conventional cluster type semiconductor processing systems. Aspects of the present technology may be used with and/or in the production of substrate processing systems (e.g., a cluster type semiconductor processing systems) having expanded substrate processing capabilities of the types described in U.S. Provisional Patent Appln. No. 63/524,272 filed June 30, 2023 and entitled "Extended Substrate Processing Systems and Methods with Additional Processing Chamber Connectability."

As shown in Fig. 1, this example expanded substrate processing system 100 includes: (a) a first substrate handling chamber 300 (an "inboard" substrate handling chamber) including a first robotic arm 320 having an end effector 320A; (b) a first load-lock module 400 (an "inboard" load-lock module) connected at one edge or facet of the first substrate handling chamber 300; (c) a second load-lock module 500 (an "outboard" load-lock module) connected at the opposite edge or facet of the first substrate handling chamber 300; and (d) a second substrate handling chamber 600 (an "outboard" substrate handling chamber) including a second robotic arm 620 having an end effector 620A. The second load-lock module 500 extends between and connects the first substrate handling chamber 300 and the second substrate handling chamber 600. The first load-lock module 400 of this example also is connected with an equipment front end module 700 that includes a third robotic arm 720 having an end effector 720A. The equipment front end module 700 may include or connect with a nitrogen gas source for providing a nitrogen gas atmosphere within the equipment front end module 700. The equipment front end module 700 receives new substrates for processing into the substrate processing system 100 and discharges processed substrates from the substrate processing system 100 via one or more loading ports 800A-800D (moving the substrates between the loading port(s) 800A-800D and the first load-lock module 400 using the robotic arm 720). While four loading ports 800A-800D are shown in the example of Fig. 1, more or fewer loading ports may be provided in other specific examples of this technology.

Each of the first substrate handling chamber 300 and the second substrate handling chamber 600 is connected with multiple substrate processing chambers 900. Substrates are transferred into the substrate processing chambers 900 where one or more layers of material are deposited onto a surface of the substrate and/or other desired substrate processing takes place. Fig. 1 shows each substrate processing chamber 900 including four substrate supports 902 onto which substrates can be placed during processing. More or fewer substrates supports 902 may be provided in the substrate processing chambers 900 (e.g., the substrate processing chambers 900 may be dual chamber modules (DCM) or quad chamber modules (QCM)). Substrate processing chambers 900 in accordance with some examples of this technology may include another four substrate supports 902 located vertically beneath the four substrate supports 902 shown in the top view of Fig. 1. Each of the substrate processing chambers 900 may have the same structures or one or more of the substrate processing chambers 900 may have a different structure from other substrate processing chambers 900 present.

Each of the first substrate handling chamber 300 and the second substrate handling chamber 600 is connected with its respective substrate processing chambers 900 via one or more gate valves 1000. While two gate valves 1000 are shown connecting substrate handling chambers 300, 600 with each of their respective substrate processing chambers 900, more or fewer gate valves 1000 may be provided with each substrate processing chamber 900, in other examples of this technology. Substrate processing chambers 900 in accordance with some examples of this technology may be connected with their respective substrate handling chamber 300, 600 by another two gate valves 1000, e.g., located vertically beneath the two gate valves 1000 shown in the top view of Fig. 1. When closed, the gate valves 1000 sealingly separate the substrate handling chambers 300, 600 from their respective substrate processing chambers 900 (so that independent atmospheric conditions may be maintained in each chamber). When open, the gate valves 1000 provide an opening (e.g., a substrate transfer slot) through which the end effector 320A, 620A of a robotic arm 320, 620 can extend to move substrates into and out of the substrate processing chamber 900. The openings through the gate valves 1000 align with substrate transfer slots provided in the substrate processing chambers 900 and the substrate handling chambers 300, 600, to enable substrates to be moved between the substrate processing chambers 900 and the substrate handling chambers 300, 600 through the gate valves 1000. Each of gate valves 1000 may have the same structures or one or more of the gate valves 1000 may have a different structure from other gate valves 1000 present.

One face of the first load-lock module 400 connects with the equipment front end module 700 by one or more gate valves 1100A (two shown in Fig. 1), and the opposite face of the first load-lock module 400 connects with the first substrate handling chamber 300 by one or more gate valves 1100B (two shown in Fig. 1). The first load-lock module 400 further includes one or more substrate supports 402 (e.g., "setplates," two shown in Fig. 1) for holding substrates while they wait to be moved into the equipment front end module 700 or the first substrate handling chamber 300. When closed, the gate valves 1100A, 1100B sealingly separate the first load-lock module 400 from the equipment front end module 700 and the substrate handling chamber 300 (so that independent atmospheric conditions may be maintained in each chamber). When open, the gate valves 1100A provide an opening (e.g., a substrate transfer slot) through which the end effector 720A of robotic arm 720 can extend to move substrates into and out of the equipment front end module 700. The openings through the gate valves 1100A align with substrate transfer slots provided in the equipment front end module 700 and the first load-lock module 400 to enable substrates to be moved between the equipment front end module 700 and the first load-lock module 400 through gate valves 1100A. When open, the gate valves 1100B provide an opening (e.g., a substrate transfer slot) through which the end effector 320A of robotic arm 320 can extend to move substrates into and out of the substrate handling chamber 300. The openings through the gate valves 1100B align with substrate transfer slots provided in the substrate handling chamber 300 and the first load-lock module 400 to enable substrates to be moved between the substrate handling chamber 300 and the first load-lock module 400 through gate valves 1100B. Each of gate valves 1100A, 1100B may have the same structure or one or more of the gate valves 1100A, 1100B may have a different structure from other gate valves 1100A, 1100B, 1000 present.

In the substrate processing system 100 of Fig. 1, one face of the second load-lock module 500 connects with the first substrate handling chamber 300 by one or more gate valves 1200A (two shown in Fig. 1), and the opposite face of the second load-lock module 500 connects with the second substrate handling chamber 600 by one or more gate valves 1200B (two shown in Fig. 1). The second load-lock module 500 further includes one or more substrate supports 502 (e.g., "setplates," two shown in Fig. 1) for holding substrates while they wait to be moved between the two substrate handling chambers 300, 600. When closed, the gate valves 1200A, 1200B sealingly separate the second load-lock module 500 from the two substrate handling chambers 300, 600 (so that independent atmospheric conditions may be maintained in each chamber). When open, the gate valves 1200A provide an opening (e.g., a substrate transfer slot) through which the end effector 320A of robotic arm 320 can extend to move substrates into and out of the first substrate handling chamber 300. The openings through the gate valves 1200A align with substrate transfer slots provided in the first substrate handling chamber 300 and the second load-lock module 500 to enable substrates to be moved between the substrate handling chamber 300 and the second load-lock module 500 through gate valves 1200A. When open, the gate valves 1200B provide an opening (e.g., a substrate transfer slot) through which the end effector 620A of robotic arm 620 can extend to move substrates into and out of the second substrate handling chamber 600. The openings through the gate valves 1200B align with substrate transfer slots provided in the second substrate handling chamber 600 and the second load-lock module 500 to enable substrates to be moved between the second substrate handling chamber 600 and the second load-lock module 500 through gate valves 1200B. Each of gate valves 1200A, 1200B may have the same structure or one or more of the gate valves 1200A, 1200B may have a different structure from other gate valves 1200A, 1200B present. Gate valves 1200A and/or 1200B also may have the same or different structures from gate valves 1100A and/or 1100B and/or from gate valves 1000.

The first lock-load module 400 may have the same structure as the second load-lock module 500 and/or the first and second load-lock modules 400, 500 may be interchangeable (e.g., so that load-lock modules 400, 500 can switch positions and/or have a modular structure). In other examples, the first lock-load module 400 and the second load-lock module 500 may have different structures and/or may not be interchangeable (e.g., so that load-lock modules 400, 500 cannot switch positions in the substrate processing system 100). Either or both load-lock modules 400, 500 may be multi-station cooling capable and/or path through types.

The substrate processing system 100 described above provides manufacturers and end users with additional flexibility, options, and the potential for increasing production capacity. For example, cluster type substrate processing system manufacturers may provide multiple product line options for customers. As one option, some customers could purchase the entire extended substrate processing system 100 as shown in Fig. 1, i.e., with two substrate handling chambers 300, 600 and two load-lock modules 400, 500. Other customers, however, may not want or need the extended and expanded substrate processing capabilities. Such customers may opt for a less expensive cluster type substrate processing system option in which the inboard substrate handling chamber 300 and one of the load-lock modules 400 or 500 are removed. Such substrate processing system may include: (a) substrate handling chamber 600 connected with (b) up to four substrate processing chambers 900 and connected with (c) one load-lock module 400 or 500, and the load-lock module 400 or 500 is connected with (d) the equipment front end module 700, which is connected with (e) one or more loading ports 800A-800D. Thus, to provide various product line options and to better meet all of its potential customer needs, a substrate processing equipment manufacturer may need to produce more substrate handling chambers 600 than substrate handling chambers 300 (as not all customers will desire the full, extended substrate processing system 100 in the form shown in Fig. 1).

But, as shown in Fig. 1, substrate handling chambers 300, 600 are not interchangeable with one another. The "inboard" substrate handling chamber 300 of this example includes six facets: (a) one long facet 300A connected with first load-lock module 400, (b) two long facets 300B, 300C connected with substrate processing chambers 900, (c) two short facets 300D, 300E that may include a single substrate transfer slot 252 in the facet width direction, and (d) one long facet 300F connected with second load-lock module 500. The "outboard" substrate handling chamber 600 of this example includes five facets: (a) one facet 600A connected with load-lock module 500 and (b) four facets 600B, 600C, 600D, and 600E connected with substrate processing chambers 900. While other options are possible, in the example of Fig. 1, the facets 600A-600E are each substantially equal in their width dimension (the side-to-side dimension).

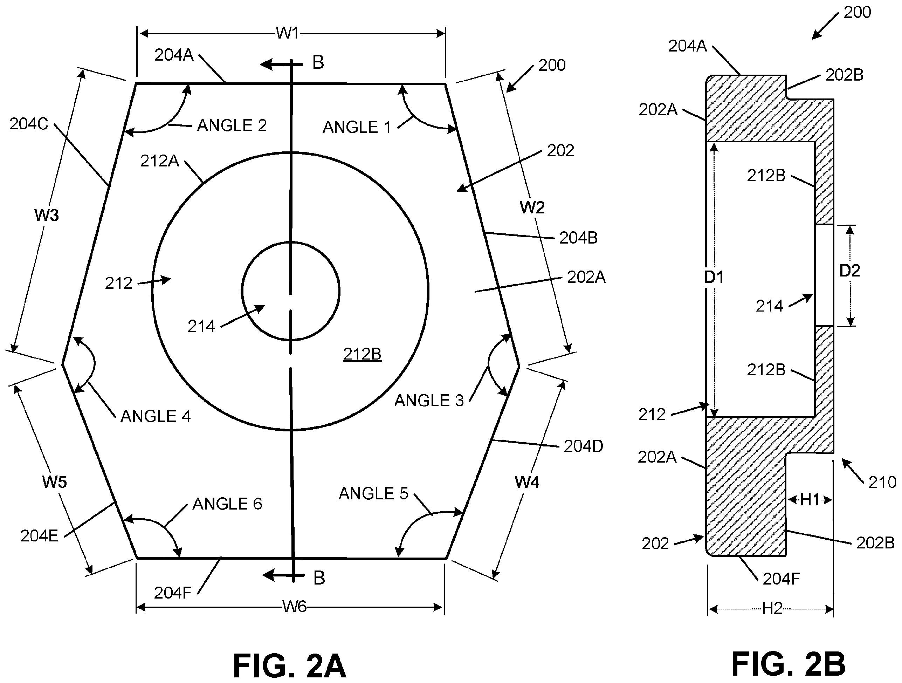

Despite their differences in overall sizes and shapes, however, in accordance with aspects of the present technology, each of the inboard substrate handling chamber 300 and the outboard substrate handling chamber 600 of this example may be made from a common or standard substrate handling chamber precursor 200. Figs. 2A-2D provide various views of a standard substrate handling chamber precursor 200 in accordance with aspects of the present technology. This standard precursor 200 can be further machined (as described in more detail below) to form either of inboard substrate handling chamber 300 or outboard substrate handling chamber 600. Thus, a manufacturer (or a supplier to that manufacturer) need only maintain this single type of substrate handling chamber precursor 200 in its inventory, and those substrate handling chamber precursors 200 can be used to make either an inboard substrate handling chamber 300 or an outboard substrate handling chamber 600, depending on the needs of the manufacturer at a given time. These features simplify the manufacturer's inventory for substrate handling chamber precursors, can reduce the overall volume of inventory needed (e.g., by not needing to maintain minimum inventory of two separate precursors), and can help avoid unexpected manufacturing delays by having precursors 200 for both substrate handling chamber 300, 600 structures available. These features also can simplify the manufacturer and/or reduce the tooling needed for making substrate handling chamber precursors 200, because a single set (or a single style) of specific tools (e.g., forging hammers, dies, anvils, etc.) and a single set of manufacturing process steps can be used to make substrate handling chamber precursors 200 for producing two (or more) different types of substrate handling chambers 300, 600.

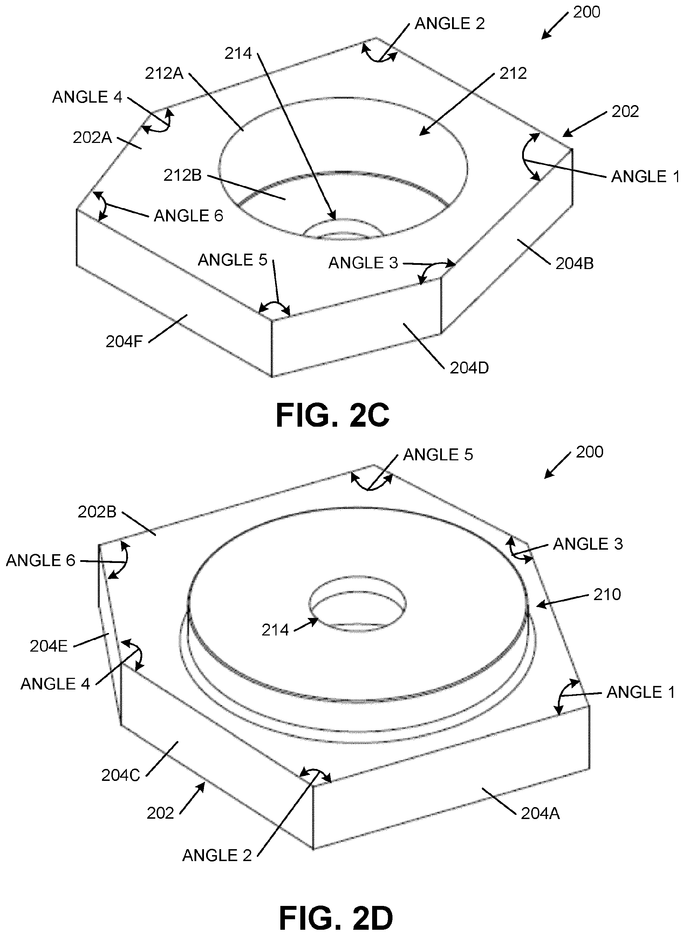

The substrate handling chamber precursor 200 of this example comprises a forging, e.g., as shown in Figs. 2A-2D. Fig. 2A shows a top view of the precursor 200; Fig. 2B shows a cross-sectional view taken along line B-B in Fig. 2A; Fig. 2C shows a top perspective view; and Fig. 2D shows a bottom perspective view. The substrate handling chamber precursor 200 of Figs. 2A-2D may be manufactured to the illustrated form by a forging process, e.g., by forging an aluminum or aluminum alloy raw material billet (e.g., aluminum 6061-t6) into the size and shape shown in Figs. 2A-2D. The example precursor 200 shown in Figs. 2A-2D may be formed as a single, unitary, one-piece construction.

As shown in Figs. 2A-2D, this example substrate handling chamber precursor 200 includes a main body portion 202 including a first major surface 202A, a second major surface 202B opposite the first major surface 202A, and multiple facets forming sidewalls between the first major surface 202A and the second major surface 202B. In the specific example of Figs. 2A-2D, the sidewalls of the substrate handling chamber precursor 200 include: (a) a first facet 204A, (b) a second facet 204B extending at an oblique angle (Angle 1) from the first facet 204A; (c) a third facet 204C extending at an oblique angle (Angle 2) from the first facet 204A; (d) a fourth facet 204D extending at an oblique angle (Angle 3) from the second facet 204B; (e) a fifth facet 204E extending at an oblique angle (Angle 4) from the third facet 204C; and (f) a sixth facet 204F extending between the fourth facet 204D and the fifth facet 204E, extending at an oblique angle (Angle 5) with respect to the fourth facet 204D, and extending at an oblique angle (Angle 6) with respect to the fifth facet 204E. Thus, as shown in Figs. 2A-2D, the main body portion 202 of the substrate handling chamber precursor 200 may have a hexagonal shape formed by the sidewalls (facets 204A-204F). Also, as shown in Figs. 2C and 2D, in this illustrated example: (a) the second major surface 202B also has a hexagonal outer perimeter shape, (b) with the same angles for Angle 1 through Angle 6, (c) with the facets 204A-204F extending perpendicular between the first major surface 202A and the second major surface 202B, and (d) with the facets 204A-204F being planar (or substantially planar). Alternatively, if desired, the second major surface 202B could have a different shape from the first major surface 202A and/or different angle measurements (e.g., if the sidewalls formed by facets 204A-204F are not perpendicular from the major surfaces 202A, 202B and/or are not planar).

Additional potential features of the geometry of substrate handing chamber precursors 200 in accordance with at least some examples of this technology include various relative sizing features. For example, in at least some examples of this technology: (a) the first facet 204A and the sixth facet 204F may be substantially equal in width (e.g., W1 ≈ W6); (b) the second facet 204B and the third facet 204C may be substantially equal in width (e.g., W2 ≈ W3); and (c) the fourth facet 204D and the fifth facet 204E may be substantially equal in width (e.g., W4 ≈ W5). The term "substantially equal" as used herein in the context of a dimensional measurement (such as height, width, length, depth, etc.) means that the two measurements (e.g., widths) being compared are equal or within 5% of each other (e.g., W1 = W6 ± (W6 × 0.05)). Additionally or alternatively, if desired, in at least some examples of this technology, any two or more of the facets 204A-204F may have a height dimension (into and out of the page of Fig. 2A) that is "substantially equal" to a height dimension of one or more other facets 204A-204F.

In accordance with at least some examples of this technology, the widths W4 and W5 of the fourth facet 204D and the fifth facet 204E, respectively, may be less than the widths W1, W2, W3, and W6 of the other facets 204A, 204B, 204C, and 204F, respectively. Additionally or alternatively, in some examples of this technology, the widths W2 and W3 of the second facet 204B and the third facet 204C, respectively, may be less than or "substantially equal" to the widths W1 and W6 of the first facet 204A and the sixth facet 204F, respectively. In some examples of this technology, at least one of the first facet 204A, the second facet 204B, the third facet 204C, and/or the sixth facet 204F will be at least 1.15 times wider than the fourth facet 204D and/or the fifth facet 204E, and in some examples, at least 1.2 times wider, at least 1.25 times wider, at least 1.3 times wider, or even at least 1.35 times wider. In other words, W1, W2, W3, and/or W6 may be at least 1.15 times W4 and/or W5 (and in some examples, at least 1.2 times, at least 1.25 times, at least 1.3 times, or even at least 1.35 times).

As some additional and/or alternative specific examples, the facets 204A through 204F may have any one or more of the following width features and/or properties:

| | | | |
|---|---|---|---|
| W4 ≤ 0.8 × W1 | W4 ≤ 0.8 × W6 | | W4 ≤0.8 × W2 |
| W4 ≤ 0.8 × W3 | W5 ≤ 0.8 × W1 | | W5 ≤ 0.8 × W6 |
| W5 ≤ 0.8 × W2 | W5 ≤ 0.8 × W3 | | W2 ≤ 0.98 × W1 |
| W2 ≤ 0.98 × W6 | W3 ≤ 0.98 × W1 | | W3 ≤ 0.98 × W6 |
| W4 ≥ 0.5 × W1 | W4 ≥ 0.5 × W6 | | W4 ≥ 0.5 × W2 |
| W4 ≥ 0.5 × W3 | W5 ≥ 0.5 × W1 | | W5 ≥ 0.5 × W6 |
| W5 ≥ 0.5 × W2 | W5 ≥ 0.5 × W3 | | W2 ≥ 0.9 × W1 |
| W2 ≥ 0.9 × W6 | W3 ≥ 0.9 × W1 | | W3 ≥ 0.9 × W6 |
| 0.5 × W1 ≤W4 ≤0.8 × W1 | | 0.5 × W6 ≤ W4 ≤0.8 × W6 | |
| 0.5 × W1 ≤ W5 ≤ 0.8 × W1 | | 0.5 × W6 ≤ W5 ≤ 0.8 × W6 | |
| 0.6 × W1 ≤ W4 ≤ 0.75 × W1 | | 0.6 × W6 ≤ W4 ≤ 0.75 × W6 | |
| 0.6 × W1 ≤ W5 ≤ 0.75 × W1 | | 0.6 × W6 ≤ W5 ≤ 0.75 × W6 | |
| 0.85 × W1 ≤ W2 ≤ 0.98 × W1 | | 0.85 × W6 ≤ W2 ≤ 0.98 × W6 | |
| 0.85 × W1 ≤ W3 ≤ 0.98 × W1 | | 0.85 × W6 ≤ W3 ≤ 0.98 × W6 | |
| 0.9 × W1 ≤ W2 ≤ 0.95 × W1 | | | 0.9 × W6 ≤ W2 ≤ 0.95 × W6 |
| 0.9 × W1 ≤ W3 ≤ 0.95 × W1 | | | 0.9 × W6 ≤ W3 ≤ 0.95 × W6 |

As some more absolute dimensions, the substrate handling chamber precursor 200 may be any desired size, e.g., dependent on the desired size of the final substrate handling chambers 300, 600. In accordance with at least some examples of this technology, W1 and W6 may be within a range of 800 mm to 1500 mm; W2 and W3 may be within a range of 700 mm to 1400 mm; and W4 and W5 may be within a range of 350 mm to 850 mm.

Additional or alternative potential features of the geometry of substrate handing chamber precursors 200 in accordance with at least some examples of this technology include various facet angle features. For example, in at least some examples of this technology: (a) Angle 1 may be substantially equal to Angle 2; (b) Angle 3 may be substantially equal to angle 4; and (c) Angle 5 may be substantially equal to Angle 6. The term "substantially equal" as used herein in the context of angle sizes means that the two angles being compared are equal or within 5 degrees of each other (e.g., Angle 1 = Angle 2 ± 5 degrees)). All of Angles 1 through Angle 6 may be obtuse angles. Additionally or alternatively, the substrate handling chamber precursor 200 may be symmetric about a line passing through the center of the first facet 204A and the sixth facet 204F (e.g., symmetric about the section line B-B shown in Fig. 2A).

Substrate handing chamber precursors 200 in accordance with at least some examples of this technology may include any one or more of the following features or properties: (i) Angle 3 and/or Angle 4 may be larger than any one or more of Angle 1, Angle 2, Angle 5, and/or Angle 6; (ii) Angle 3 and/or Angle 4 may be larger than each of Angle 1, Angle 2, Angle 5, and Angle 6; (iii) Angle 5 and/or Angle 6 may be larger than either or both of Angle 1 and/or Angle 2; (iv) Angle 3 and/or Angle 4 may be at least 30 degrees larger than any one or more of Angle 1, Angle 2, Angle 5, and/or Angle 6; (v) Angle 3 and/or Angle 4 may be at least 30 degrees larger than each of Angle 1, Angle 2, Angle 5, and Angle 6; (vi) Angle 5 and/or Angle 6 may be at least 4 degrees larger than either or both of Angle 1 and/or Angle 2; (vii) Angle 3 and/or Angle 4 may be 145 degrees ± 20 degrees; (viii) Angle 3 and/or Angle 4 may be 145 degrees ± 10 degrees; (ix) Angle 1 and/or Angle 2 may be 105 degrees ± 20 degrees; (x) Angle 1 and/or Angle 2 may be 105 degrees ± 10 degrees; (xi) Angle 5 and/or Angle 6 may be 110 degrees ± 20 degrees; and/or (xii) Angle 5 and/or Angle 6 may be 110 degrees ± 10 degrees.

The example substrate handling chamber precursor 200 of Figs. 2A-2D further includes a projection 210 extending from the second major surface 202B and in a direction away from the first major surface 202A. In this illustrated example, the main body portion 202 and the projection 210 of the substrate handling chamber precursor are formed as a single, unitary one-piece, component part, e.g., during a forging process. A recess 212 is defined extending inward from the first major surface 202A toward the second major surface 202B. In this specific example, the recess 212 extends inward from the first major surface 202A in an area of the main body portion 202 corresponding to the location of the projection 210, e.g., as shown in Figs. 2A-2C. This recess 212 includes a bottom surface 212B. The recess 212 of this example extends inward beyond a location of the second major surface 202B such that the bottom surface 212B is located within the interior of the projection 210, as shown in Fig. 2B. The recess 212 may form a top opening 212A for the substrate handling chamber 300 or 600 to be formed from the substrate handling chamber precursor 200 and provides an opening for access to an interior chamber of that substrate handling chamber 300 or 600, as will be described in more detail below. The top of the recess 212 around the opening 212A at the first major surface 202A may form (or may be formed into) a seat for engaging a lid (that closes off the interior chamber of the final substrate handling chamber 300, 600 structure).

Figs. 2B-2D further illustrate that the projection 210 of this example has a cylindrical shape extending downward from the second major surface 202B. While other shapes are possible, the projection 210 of this specific example substrate handling chamber precursor 200 includes a round cylindrical structure (having a round transverse cross-section shape) extending downward from the second major surface 202B. Also, while other shapes are possible, the recess 212 of this specific example substrate handling chamber precursor 200 includes a circular perimeter having a first diameter (D1, see Fig. 2B) at the first major surface 202A and forms a circular, cylindrical recess 212. Projection 210 may have a height dimension H1 that makes up about 25% to 50% (and in some examples, 30% to 45%) of an overall height dimension H2 of the substrate handling chamber precursor 200. See Fig. 2B.

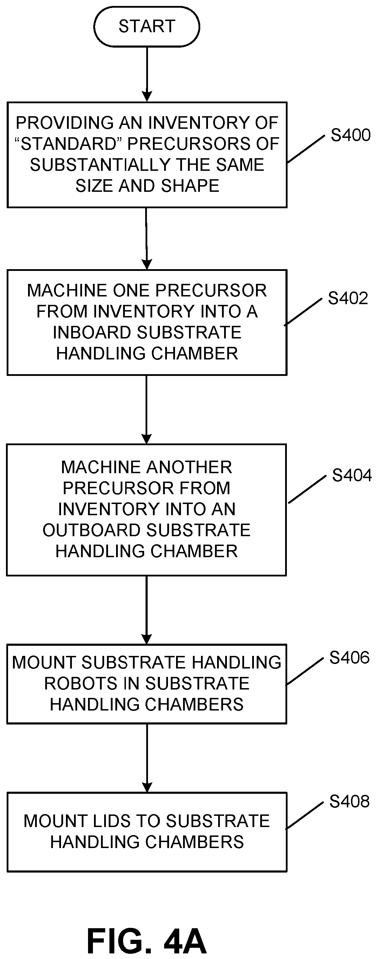

Additionally, the substrate handling chamber precursor 200 of this illustrated example further includes a through hole opening 214 extending from the bottom surface 212B of the recess 212 and through the projection 210 to open at the bottom of the precursor 200. The bottom surface 212B of the recess 212 around the through hole opening 214 may form (or may be formed into) a seat for mounting a robotic arm 320 or 620 in the final substrate handling chamber 300, 600. As will be described in more detail below in conjunction with Figs. 4A-4C, a lip of a mounting area for the robotic arm 320, 620 may engage the area of the bottom surface 212B around the through hole opening 214 and the motor (and/or other portion) of the robotic arm 320, 620 may extend into the through hole opening 214 below the bottom surface 212B.

Also, while other shapes are possible, the through hole opening 214 of this specific example substrate handling chamber precursor 200 includes a circular perimeter having a second diameter (D2, see Fig. 2B), e.g., at the bottom surface 212B of the recess 212. In at least some examples of this technology, D2 may be less than one half of D1 (i.e., D2 ≤ 0.5 × D1 (and in some examples, less than 0.45 × D1 or even less than 0.4 × D1)). As some absolute dimensions: (a) D1 may be less than 1000 mm (and in some examples, less than 900 mm) and/or greater than 600 mm (and in some examples, greater than 750 mm); and/or (b) D2 may be less than 500 mm (and in some examples, less than 400 mm) and/or greater than 200 mm (and in some examples, greater than 300 mm).

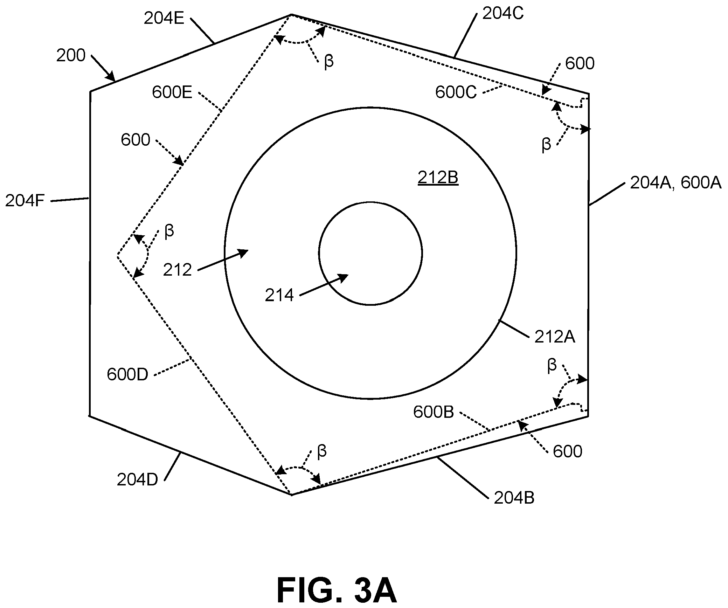

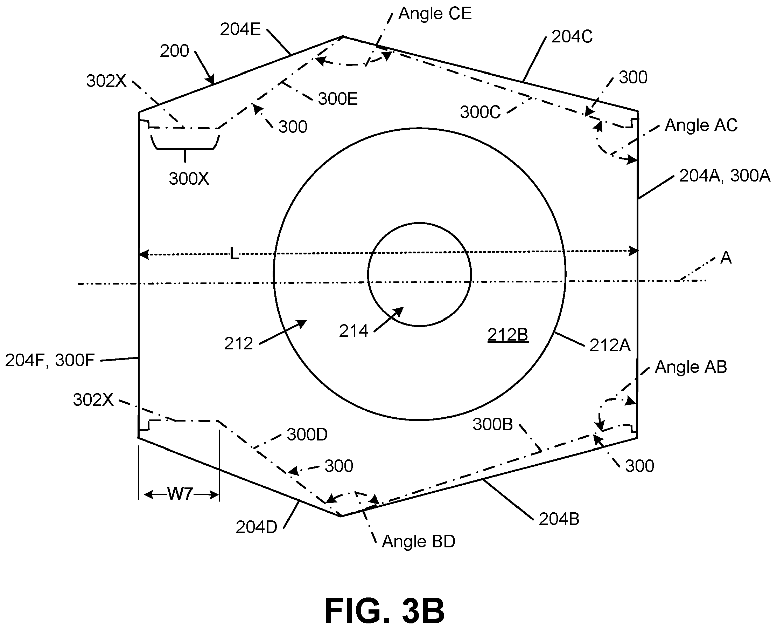

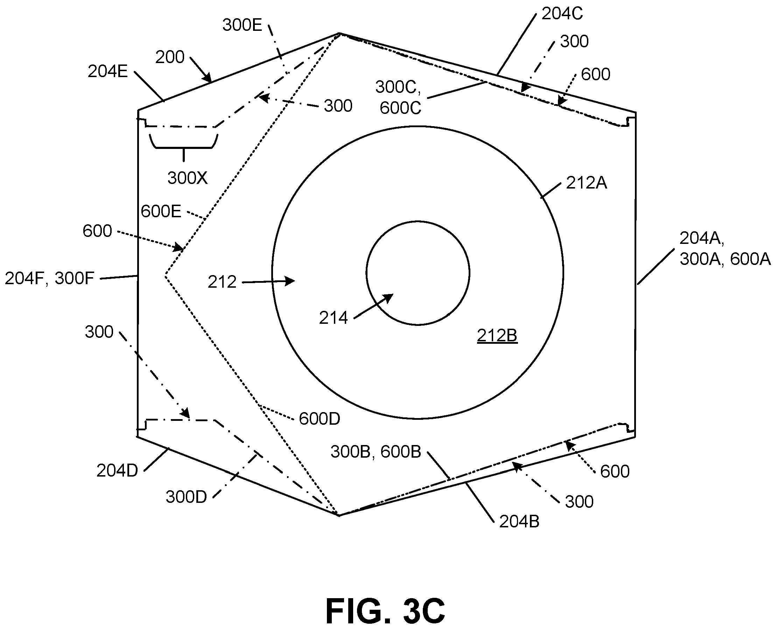

Figs. 3A-3C show top views of example substrate handling chamber precursors 200 in solid lines with the outline of final substrate handling chambers 300, 600 to be formed from the precursors 200 shown in broken lines. In this manner, Fig. 3A shows how the outboard substrate handling chamber 600 can be formed from a substrate handling chamber precursor 200 and Fig. 3B shows how the inboard substrate handling chamber 300 can be formed from a substrate handling chamber precursor 200 of the same size, shape, dimensions, etc. Fig. 3C shows the outlines of both the inboard substrate handling chamber 300 (in dot-dash lines) and the outboard substrate handling chamber 600 (in broken lines) superimposed on a single substrate handling chamber precursor 200 outline (in solid lines), to show the overlapping nature, the similarities, and the differences in shapes for these example products.

As shown in Fig. 3A, to create the outboard substrate handling chamber 600, the exterior surface of a substrate handling chamber precursor 200 is machined to remove material at the fourth facet 204D, the fifth facet 204E, and the sixth facet 204F to create facet 600D and facet 600E of the substrate handling chamber 600. Additionally, in this example, some machining occurs at the second facet 204B and third facet 204C of the substrate handling chamber precursor 200 to form the second facet 600B and third facet 600C of the substrate handling chamber 600. The first facet 204A of the substrate handling chamber precursor 200 of this illustrated example is formed to substantially match up with the first facet 600A of the outboard substrate handling chamber 600.

In at least some examples of this technology, the angles β defined between adjacent facets 600A-600E of the outboard substrate handling chamber 600 may be "substantially equal" to one another, e.g., such that the facets 600A-600E substantially form a regular pentagon. But other angular arrangements for the facets 600A-600E of an outboard substrate handling chamber 600 are possible in other specific examples of this technology.

As shown in Fig. 3B, to create the inboard substrate handling chamber 300, the exterior surface of a substrate handling chamber precursor 200 is machined to remove material at the fourth facet 204D and at the fifth facet 204E to create the shorter fourth facet 300D and the shorter fifth facet 300E and to create an extension region 300X of the substrate handling chamber 300. The extension region 300X provides some additional length in the substrate transfer axis direction A of the substrate handling chamber 300, e.g., to allow more room in the final assembled substrate processing system 100 (see Fig. 1) to access facets 300D and 300E. The extension region 300X can help provide additional room to allow a substrate processing chamber or other equipment 910 to be mounted to facets 300D and 300E of substrate handling chamber 300, e.g., as shown in broken lines in Fig. 1, to provide even further expanded capabilities.

Aspects of this technology additionally relate to substrate handling chambers of the types described herein, e.g., in which the substrate handling chamber includes multiple facets (e.g., of the types described above in conjunction with Fig. 3B) in which one facet (e.g., facet 300F) is offset from other facets (e.g., 300A-300E) by an extended section (e.g., extension region 300X). Fig. 3B shows substrate handling chamber 300 including: (a) a first facet 300A, (b) a second facet 300B extending at an oblique angle (Angle AB) from the first facet 300A; (c) a third facet 300C extending at an oblique angle (Angle AC) from the first facet 300A; (d) a fourth facet 300D extending at an oblique angle (Angle BD) from the second facet 300B; and (e) a fifth facet 300E extending at an oblique angle (Angle CE) from the third facet 300C. The extension region 300X extends outward from the fourth facet 300D and the fifth facet 300E, e.g., in a substrate transfer axis direction A and/or in a length direction L (the direction from the first facet 300A to the sixth facet 300F). The extension region 300X of this example is formed by parallel sidewalls 302X of the substrate handling chamber 300 that extend from the fourth facet 300D and fifth facet 300E to a sixth facet 300F. In some examples of this technology, the parallel sidewalls 302X forming the extension region 300X may be substantially perpendicular (e.g., ± 5 degrees) to the sixth facet 300F. Angle AB may be substantially equal to angle AC and/or Angle BD may be substantially equal to Angle CE. Additionally or alternatively, if desired, the first facet 300A and the sixth facet 300F may have substantially equal widths; the second facet 300B and the third facet 300C may have substantially equal widths; and/or the fourth facet 300D and the fifth facet 300E may have substantially equal widths (with these "widths" corresponding to the dimensional directions for the widths W1 to W6 as generally shown in Fig. 2A (horizontal, side-to-side directions across facets)). The opposite sidewalls 302X of the extension region 300X also may have substantially equal widths W7 (see Fig. 3B).

Extension region 300X may be any desired size and/or shape. **In** some examples, the extension region 300X may form at least 5% of a length dimension L between the first facet 300A and the sixth facet 300F, and in some examples, at least 8%, at least 10%, at least 12%, or even at least 15% of the length L). Additionally or alternatively, in some examples, the extension region 300X may form less than 30% of a length dimension L between the first facet 300A and the sixth facet 300F, and in some examples, less than 25%, or even less than 20% of the length L).

Additionally, in this example, some machining occurs at the second facet 204B and third facet 204C of the substrate handling chamber precursor 200 to form the second facet 300B and third facet 300C of the substrate handling chamber 300. The first facet 204A of the substrate handling chamber precursor 200 of this illustrated example is formed to substantially match up with the first facet 300A of the inboard substrate handling chamber 300. Similarly, the sixth facet 204F of the substrate handling chamber precursor 200 of this illustrated example is formed to substantially match up with the sixth facet 300F of the inboard substrate handling chamber 300.

Fig. 3C shows a top view with the outline of both the inboard substrate handling chamber 300 and the outboard substrate handling chamber 600 superimposed on the outline of the substrate handling chamber precursor 200. This view enables a direct comparison of the material to be removed from a substrate handling chamber precursor 200 to form each of the inboard substrate handling chamber 300 and the outboard substrate handling chamber 600. As evident from Fig. 3C, while both substrate handling chambers 300, 600 may be formed from a commonly sized and shaped precursor 200 (also called a "standard" precursor 200 herein), the outboard substrate handling chamber 600 has fewer facets located around and forming its exterior perimeter shape and sidewalls (e.g., 5 facets in this illustrated example) than the number of facets located around and forming the exterior perimeter shape and sidewalls of the inboard substrate handling chamber 300 (e.g., at least 6 facets in this illustrated example). Additionally or alternatively, as also evident from Fig. 3C, more material (e.g., a greater volume of material) is removed from a standard precursor 200 to form the outboard substrate handling chamber 600 than is removed from a standard precursor 200 to form the inboard substrate handling chamber 300. As shown in Fig. 3C, the inboard substrate handling chamber 300 has a larger "footprint" from the top view than the outboard substrate handling chamber 600.

As also evident from Fig. 3C, in this illustrated example, the first facet 300A, second facet 300B, and third facet 300C of the inboard substrate handling chamber 300 match (or substantially match) the size and/or shape of the first facet 600A, second facet 600B, and third facet 600C of the outboard substrate handling chamber 600. The precursor 200 may be sized and shaped such that little to no machining may be needed at the first major surface 202A, the second major surface 202B, and/or the projection 210 when forming a precursor 200 into the inboard substrate handling chamber 300 and/or into the outboard substrate handling chamber 600. Thus, in at least some examples of this technology, the final inboard substrate handling chamber 300 and/or the final outboard substrate handling chamber 600 may include the projection 210 structure extending outward from a main body portion of the substrate handling chamber 300, 600 that includes the facets 300A-300F (and extension region 300X) or the facets 600A-600E.

Figs. 4A-4C illustrate additional features of substrate handling chambers, systems, and methods in accordance with examples of this technology. Fig. 4A provides a flow chart of methods in accordance with some aspects of this technology. At step S400, the method includes providing or accessing an inventory of "standard" substrate handling chamber precursors 200, e.g., plural substrate handling chamber precursors having a standard size and shape. More specifically, the "inventory" may include plural substrate handling chamber precursors 200 (e.g., of the types shown and described above in conjunction with Figs. 2A-2D) in which each substrate handling chamber precursor 200 has a set of dimensions and features (e.g., height, width, depth, size, shape, features (e.g., projections 210, recesses 212, through hole openings 214, etc.)) that is substantially equal to the sets of dimensions and feature present in other substrate handling chamber precursors 200 of the inventory. In this manner, all of the standard substrate handling chamber precursors 200 in the inventory may be substantially equivalent in size and shape. The terms "providing" a substrate handling chamber precursor and/or "providing" an inventory, as used herein in this context, mean that a party in some manner makes the substrate handling chamber precursor(s) 200 and/or inventory available for use in forming substrate handling chamber 300, 600 products. "Providing" may include, but is not limited to: purchasing substrate handling chamber precursor(s) 200 (e.g., directly or as part of an order for purchasing a final substrate handling chamber product); ordering substrate handling chamber precursor(s) 200 for delivery to another (e.g., a vendor for machining the precursor(s) 200); shipping substrate handling chamber precursor(s) 200 to another; storing substrate handling chamber precursor(s) 200 for future use; retrieving substrate handling chamber precursor(s) 200 from a storage facility or inventory; transmitting a product order to a vendor where fulfilment of that order will include use of substrate handling chamber precursor(s) 200; and the like.

When orders for a substrate processing system 100 or individual substrate handling chambers 300, 600 are received, a manufacturer then may machine a first substrate handling chamber precursor 200 to remove an amount of material from that substrate handling chamber precursor 200 to form an inboard substrate handling chamber 300 body at S402. Machining of this type may include CNC milling and/or other process steps to form the inboard substrate handling chamber 300 body to include an exterior perimeter shape having a first number of facets (e.g., at least six facets) located around and forming sidewalls of the inboard substrate handling chamber 300 body, e.g., as shown in Fig. 3B. The exterior perimeter shape of the inboard substrate handling chamber 300 body also may be formed to include the extension region 300X shown in Fig. 3B. At Step S404, the manufacturer then may machine a second substrate handling chamber precursor 200 to remove an amount of material from that substrate handling chamber precursor 200 to form an outboard substrate handling chamber 600. Machining of this type may include CNC milling and/or other process steps to form the outboard substrate handling chamber 600 body to include an exterior perimeter shape having a second number of facets located around and forming sidewalls of the outboard substrate handling chamber 600 body, e.g., as shown in Fig. 3A. As described above and as evident from Figs. 3A-3C, the second number of facets (e.g., no more than five facets) for the outboard substrate handling chamber 600 may differ from the first number of facets formed in the inboard substrate handling chamber 300 (e.g., at least six facets). Also, the amount (e.g., volume) of material removed from the precursor 200 to form the outboard substrate handling chamber 600 may be greater than the amount (e.g., volume) of material removed from the precursor 200 to form the inboard substrate handling chamber 300.

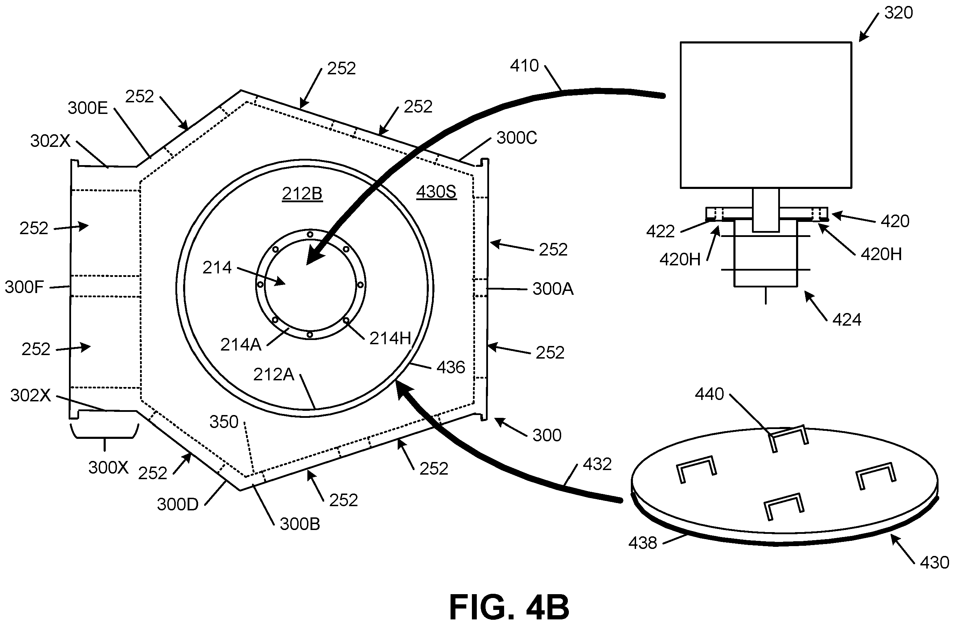

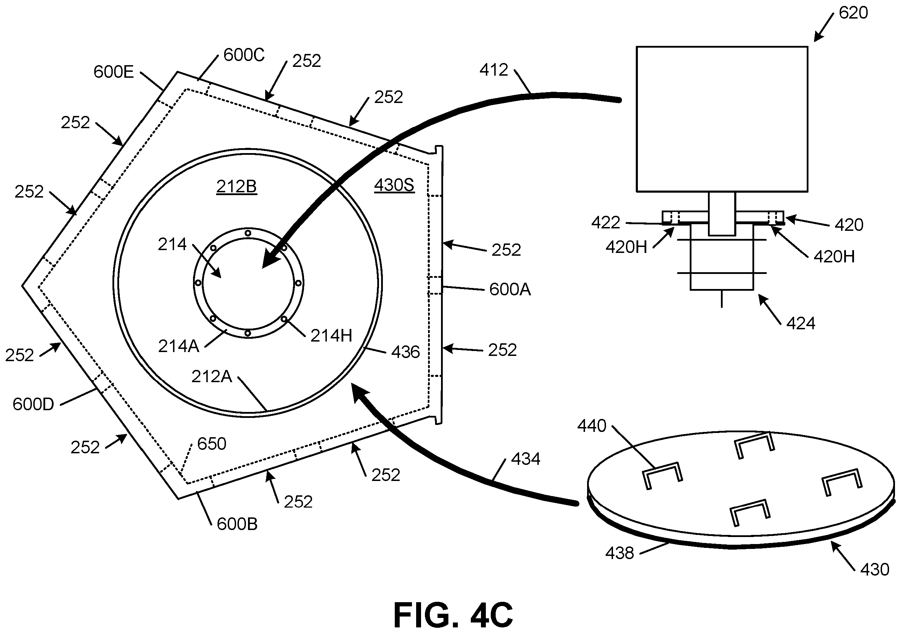

Steps S402 and S404 may include features of forming the final inboard substrate handling chamber 300 body and the outboard substrate handling chamber 600 body in addition to the steps for forming the exterior shapes of these chambers 300, 600. As discussed above, substrate handling chambers 300, 600 include an interior chamber in which robotic arms 320, 620, respectively, are mounted and substrate transfer slots through which substrates are moved to other components. The substrate handling chamber precursor 200 of this example, includes recess 212 that forms an opening 212A at the first major surface 202A. Formation of the substrate handling chamber 300, 600 bodies may include further action (e.g., machining, such as CNC milling) to form the remainder of the substrate handling chamber 300, 600 bodies. For example, as shown in Fig. 4B (and optionally as part of Step S402), starting at the sidewall of recess 212, the interior of the substrate handling chamber precursor 200 can be hollowed out to form interior chamber 350 (with its interior sidewalls shown as broken lines in the top view of Fig. 4B). Further, substrate transfer slots 252 can be formed (machined, such as by CNC milling) in the facets 300A-300F so that substrates can be moved from the interior chamber 350 of the substrate handling chamber 300 to other equipment engaged with the substrate handling chamber 300. The facets 300A-300F provide faces for engaging gate valves and/or other equipment, e.g., as shown in Fig. 1. Additionally, as shown in Fig. 4C (and optionally as part of Step S404), starting at the sidewall of recess 212, the interior of the substrate handling chamber precursor 200 can be hollowed out to form interior chamber 650 (with its interior sidewalls shown as broken lines in the top view of Fig. 4C). Further, substrate transfer slots 252 can be formed (machined, such as by CNC milling) in the facets 600A-600E so that substrates can be moved from the interior chamber 650 of the substrate handling chamber 600 to other equipment engaged with the substrate handling chamber 600. The facets 600A-600E provide faces for engaging gate valves and/or other equipment, e.g., as shown in Fig. 1. Any desired number of substrate transfer slots 252 can be formed in the individual facets 300A-300F and the individual facets 600A-600E, including, for example, one or more of: (a) one substrate transfer slot 252 per facet (e.g., in one or more of facets 300D and 300E); (b) two vertically spaced substrate transfer slots 252 per facet (e.g., in one or more of facets 300D and 300E); (c) two horizontally spaced substrate transfer slots 252 per facet (e.g., in one or more of facets 300A-300C, 300F, and 600A-600E); and/or (d) four spaced substrate transfer slots 252 per facet in a 2 × 2 matrix (e.g., in one or more of facets 300A-300C, 300F, and 600A-600E); etc.

Figs. 4A-4C show additional potential features of substrate processing systems 100, substrate handling chambers 300, 600, and methods in accordance with aspects of this technology. Fig. 4A includes Step S406 of mounting a substrate handling chamber robot in the substrate handling chambers 300, 600. Fig. 4B illustrates insertion of robotic arm 320 and its associated components in substrate handling chamber 300 (arrow 410) and Fig. 4C illustrates insertion of robotic arm 620 and its associated components in substrate handling chamber 600 (arrow 412). The steps of forming the substrate handling chambers 300, 600 may include, if necessary, machining or other action around the through hole opening 214 to form structure for mounting the robotic arm 320, 620, respectively. As shown in Figs. 4B and 4C, this may include forming a recessed seating area 214A around the through hole opening 214 and/or forming one or more holes 214H (e.g., for bolts or other fasteners) through bottom surface 212B of the substrate handling chamber 300, 600 body. Robotic arms 320, 620 may include a retaining element 420 sized and shaped to fit over the through hole opening 214 and, when present, fit into the recessed seating area 214A at the bottom of substrate handling chambers 300, 600. The retaining element 420 may include one or more openings 420H configured to align with corresponding holes 214H located at the bottom surface of the substrate handling chamber 300, 600 body. The bottom of the retaining element 420 and/or the exposed surface around the through hole opening 214 (e.g., in recessed seating area 214A) may include a seal 422. The retaining element 420 of robotic arm 320, 620 may be mounted around the through hole opening 214 and fastened (and sealed) in place, e.g., using bolts extending through holes 214H and 420H and/or other desired type of fastener(s).

When mounted, a portion of the robotic arm 320, 620 system may extend into and/or through the through hole opening 214, e.g., to a location below the bottom surface of the substrate handling chamber 300, 600 (e.g., below the bottom of the projection 210). In these illustrated examples, the motor 424 of the robotic arm 320, 620 will extend to a location outside of the interior chamber 350, 650 of the substrate handling chamber 300, 600, respectively. This may make the motor 424 accessible from outside the substrate handling chamber 300, 600.

Fig. 4A also includes Step S408 of mounting a lid 430 to the substrate handling chambers 300, 600. Fig. 4B illustrates mounting of lid 430 over the opening 212A at the top surface 430S of substrate handling chamber 300 (arrow 432), and Fig. 4C illustrates mounting of lid 430 over the opening 212A at the top surface 430S of substrate handling chamber 600 (arrow 434). The top surface 430S of the substrate handling chamber(s) 300, 600 may correspond to a portion of the first major surface 202A of the precursor 200. If necessary or desired, an area around the perimeter of the opening 212A at the top surface 430S of the substrate handling chamber(s) 300, 600 may be machined or otherwise constructed, e.g., to form a lid seating area 436 or recess. The bottom of the lid 430 and/or the exposed surface around the opening 212A may include a seal 438 so that the lid 430 is capable of sealing off the opening 212A. Additional fasteners may be provided to fix the lid 430 in place over the opening 212A.

Figs. 4B and 4C further show the lid 430 including one or more handle elements 440. The handle elements 440 may be manually engaged to move the lid 430 onto and off of the top surface 430A of the substrate handling chamber(s) 300, 600 and over opening 212A. Alternatively, one or more handle elements 440 (or other suitable structures) may be provided to engage a system for moving the lid 430 (e.g., for engaging a hoist mounted on a gantry, etc.). As yet other examples, if desired, the lid 430 may be provided as part of lid moving systems and methods of the types described in U.S. Provisional Patent Appln. No. 63/526,759 filed July 14, 2023 and entitled "Lid Moving Systems and Methods for Chambers or Containers."

In at least some examples of this technology, the substrate handling chamber precursors 200 will be formed in a size and shape (e.g., during forging) such that much of it will not be needed to be further machined (or subject to relatively minor machining) in making the substrate handling chambers 300, 600. For example, when making inboard substrate handling chamber 300, the final substrate handling chamber 300's top surface 430A, bottom surface, first facet 300A and sixth facet 300F may correspond to the first major surface 202A, the second major surface 202B, first facet 204A, and sixth facet 204F, respectively, of a precursor 200 from which it was formed (e.g., with little or no further machining or alterations). Additionally, in some examples, the projection 210, through hole opening 214, and bottom surface 212B of the recess 212 from the precursor 200 may remain in the substrate handling chamber 300 final product (e.g., with little or no further machining or alterations). Additionally or alternatively, when making outboard substrate handling chamber 600, the final substrate handling chamber 600's top surface 430A, bottom surface, and first facet 600A may correspond to the first major surface 202A, the second major surface 202B, and first facet 204A, respectively, of a precursor 200 from which it was formed (e.g., with little or no further machining or alterations). Additionally, in some examples, the projection 210, through hole opening 214, and bottom surface 212B of the recess 212 from the precursor 200 may remain in the substrate handling chamber 600 final product (e.g., with little or no further machining or alterations). These features help reduce the additional machining and steps needed to form the final substrate handling chambers 300, 600 from the precursors 200.

As described above, advantageous aspects of this technology relate to the fact that, despite differences in overall sizes and shapes, each of the inboard substrate handling chamber 300 and the outboard substrate handling chamber 600 may be made from a standard substrate handling chamber precursor 200. Thus, a manufacturer (or a supplier to that manufacturer) need only maintain this single type of substrate handling chamber precursor 200 in its inventory, and those substrate handling chamber precursors 200 can be used to make either of an inboard substrate handling chamber 300 or an outboard substrate handling chamber 600, depending on the needs of the manufacturer at a given time. These features simplify the manufacturer's inventory for substrate handling chamber precursors, can reduce the overall volume of the inventory (by not needing to maintain minimum inventory of two separate precursors), and can help avoid unexpected manufacturing delays by having precursors for both substrate handling chamber 300, 600 structures available. These features also can help reduce the tooling needed for making substrate handling chamber precursors 200, because a single set (or a single style) of specific tools (e.g., forging hammers, dies, anvils, etc.) can be used to make substrate handling chamber precursors 200 for producing two different types of substrate handling chambers 300, 600. Also, these features can simplify the manufacture of precursors 200 by requiring only one method and procedure for making precursors 200 for multiple styles of substrate handling chambers 300, 600.

The headings provided herein, if any, are for convenience only and do not necessarily affect the scope or meaning of the devices and methods disclosed herein. The scope of the invention is defined by the claims and does not extend beyond them.

## Claims

1. A substrate handling chamber precursor (200), comprising:
a main body portion (202) including a first major surface (202A), a second major surface (202B) opposite the first major surface (202A), and multiple facets forming sidewalls (204A to 204 F) extending between the first major surface (202A) and the second major surface (202B);
a projection (210) extending from the second major surface (202B) and in a direction away from the first major surface (202A), wherein the main body portion (202) and the projection (210) are formed as a single, one-piece, forged component part;
a first recess (212) extending inward from the first major surface (202A), the first recess (212) including a bottom surface (212B); and
a through hole opening (214) extending from the bottom surface (212B) of the first recess (212) through the projection (210);
wherein the substrate handling chamber precursor (200) requires machining to form therefrom a substrate handling chamber (300, 600), and wherein the substrate handling chamber precursor (200) is configured to be machined so as to form therefrom substrate handling chambers (300, 600) of at least two different types.

2. The substrate handling chamber precursor according to claim 1, wherein the projection (210) comprises a round cylindrical structure extending from the second major surface (202B).

3. The substrate handling chamber precursor according to claim 1 or 2, wherein the first recess (212) defines a circular perimeter having a first diameter and the through hole opening (214) defines a circular perimeter having a second diameter, and wherein the second diameter is less than one half the first diameter.

4. The substrate handling chamber precursor according to any one of claims 1-3, wherein the multiple facets forming the sidewalls (204A to 204F) of the main body portion (202) form a hexagonal shape.

5. The substrate handling chamber precursor according to claim 4, wherein the multiple facets (204A to 204F) include: (a) a first facet (204A), (b) a second facet (204B) extending from the first facet (204A) at a first angle, (c) a third facet (204C) extending from the first facet (204A) at a second angle, (d) a fourth facet (204D) extending from the second facet (204B) at a third angle, (e) a fifth facet (204E) extending from the third facet (204C) at a fourth angle, and (f) a sixth facet (204F) extending between the fourth facet (204D) and the fifth facet (204E).

6. The substrate handling chamber precursor according to claim 5, wherein the second angle is substantially equal to the first angle and the third angle is substantially equal to the fourth angle.

7. The substrate handling chamber precursor according to claim 6, wherein the third angle is at least 30 degrees larger than the first angle.

8. The substrate handling chamber precursor according to claim 6 or 7, wherein the sixth facet (204F) extends from the fourth facet (204D) at a fifth angle, wherein the sixth facet (204F) extends from the fifth facet (204E) at a sixth angle, and wherein the fifth angle is substantially equal to the sixth angle.

9. The substrate handling chamber precursor according to claim 8, wherein the third angle is at least 30 degrees larger than the first angle and at least 30 degrees larger than the fifth angle.

10. The substrate handling chamber precursor according to claim 5, wherein each of the first facet (204A) and the sixth facet (204F) is wider than each of the second facet (204B), the third facet (204C), the fourth facet (204D), and the fifth facet (204E).

11. The substrate handling chamber precursor according to claim 5, wherein each of the first facet (204A), the second facet (204B), the third facet (204C), and the sixth facet (204F) is at least 1.3 times wider than each of the fourth facet (204D) and the fifth facet (204E).

12. A method of manufacturing substrate handling chambers, comprising:
providing a first substrate handling chamber precursor (200) as defined in claim 1 and a second substrate handling chamber precursor (200) as defined in claim 1, the first substrate handling chamber precursor (200) having a first set of dimensions and the second substrate handling chamber precursor (200) having a second set of dimensions that are substantially equal to corresponding dimensions of the first set of dimensions such that the first substrate handling chamber precursor (200) and the second substrate handling chamber precursor (200) are substantially equivalent in size and shape;
machining the first substrate handling chamber precursor (200) to remove a first amount of material from the first substrate handling chamber precursor to form a first substrate handling chamber body (300), wherein the first substrate handling chamber body (300) includes a first exterior perimeter shape having a first number of facets (300A to 300F) located around and forming first sidewalls of the first substrate handling chamber body (300); and
machining the second substrate handling chamber precursor (200) to remove a second amount of material from the second substrate handling chamber precursor (200) to form a second substrate handling chamber body (600), wherein the second substrate handling chamber body (600) includes a second exterior perimeter shape having a second number of facets (600A to 600E) located around and forming second sidewalls of the second substrate handling chamber body (600), wherein the second number of facets (600A to 600E) is less than the first number of facets (300A to 300F), and wherein the second amount of material is greater than the first amount of material.

13. The method according to claim 12, wherein the first recess (212) defines a circular perimeter having a first diameter and the through hole opening (214) defines a circular perimeter having a second diameter, and wherein the second diameter is less than one half the first diameter.

14. The method according to claim 12, wherein the projection of each of the first substrate handling chamber precursor (200) and the second substrate handling chamber precursor (200) comprises a round cylindrical structure extending from the second major surface (202B).

15. The method according to any one of claims 12-14, wherein the first number of facets (300A to 300F) forming the first sidewalls of the first substrate handling chamber body (300) comprises at least six facets (300A to 300F), and wherein the second number of facets (600A to 600E) forming the second sidewalls of the second substrate handling chamber body (600) comprises no more than five facets (600A to 600E).

16. The method according to any one of claims 12-14, wherein each of the first substrate handling chamber precursor (200) and the second substrate handling chamber precursor (200) includes: (a) a first facet (204A), (b) a second facet (204B) extending from the first facet (204A) at a first angle, (c) a third facet (204C) extending from the first facet (204A) at a second angle, (d) a fourth facet (204D) extending from the second facet (204B) at a third angle, (e) a fifth facet (204E) extending from the third facet (204C) at a fourth angle, and (f) a sixth facet (204F) extending between the fourth facet (204D) and the fifth facet (204E).

17. The method according to claim 16, wherein the second angle is substantially equal to the first angle and the third angle is substantially equal to the fourth angle.

18. The method according to claim 17, wherein the sixth facet (204F) extends from the fourth facet (204D) at a fifth angle, wherein the sixth facet (204F) extends from the fifth facet (204E) at a sixth angle, and wherein the fifth angle is substantially equal to the sixth angle.

19. The method according to claim 18, wherein the third angle is at least 30 degrees larger than the first angle and/or at least 30 degrees larger than the fifth angle.

20. The method according to claim 16, wherein each of the first facet (204A) and the sixth facet (204F) is wider than each of the second facet (204B), the third facet (204C), the fourth facet (204D), and the fifth facet (204E).

21. The method according to claim 16, wherein each of the first facet (204A), the second facet (204B), the third facet (204C), and the sixth facet (204F) is at least 1.3 times wider than each of the fourth facet (204D) and the fifth facet (204E).

22. The method according to according to any one of claims 12 to 21, wherein the first substrate handling chamber precursor (200) and the second substrate handling chamber precursor (200) are provided as part of an inventory of precursors (200) provided for forming multiple substrate handling chamber bodies (300, 600), wherein each precursor (200) of the inventory includes a set of dimensions that are substantially equal to corresponding dimensions of the first set of dimensions such that all precursors (200) in the inventory have substantially equivalent sizes and shapes.

23. The method according to any one of claims 12 to 22, wherein the first substrate handling chamber body (300) is formed to include: (a) a first top surface (430S), (b) a first bottom surface located opposite the first top surface, and (c) a first chamber extending inward from the first top surface (430S), and wherein the method further comprises: engaging a first lid (430) with the first substrate handling chamber body (600), wherein the first lid (430) is sized, shaped, and movably positionable to cover a first opening (212A) to the first chamber at the first top surface (430S); and/or
wherein the second substrate handling chamber body (600) is formed to include: (a) a second top surface (430S), (b) a second bottom surface located opposite the second top surface, and (c) a second chamber extending inward from the second top surface (430S), and wherein the method further comprises: engaging a second lid (430) with the second substrate handling chamber body (600), wherein the second lid (430) is sized, shaped, and movably positionable to cover a second opening (212A) to the second chamber at the second top surface (430S).

24. The method according to any one of claims 12 to 22, wherein the first substrate handling chamber body (300) is formed to include: (a) a first top surface (430S), (b) a first bottom surface located opposite the first top surface, (c) a first chamber (212) extending inward from the first top surface (430S) to a first interior bottom face (212B), and (d) a first through hole opening (214) extending from the first interior bottom face (212B) to the first bottom surface, and wherein the method further comprises: placing a first substrate transfer robot in the first chamber (212) such that a first portion of the first substrate transfer robot extends into the first through hole opening (214) below the first interior bottom face (214B); and/or
wherein the second substrate handling chamber body (600) is formed to include: (a) a second top surface (430S), (b) a second bottom surface located opposite the second top surface, (c) a second chamber extending (212) inward from the second top surface (430S) to a second interior bottom face (212B), and (d) a second through hole opening (214) extending from the second interior bottom face (212B) to the second bottom surface, and wherein the method further comprises: placing a second substrate transfer robot in the second chamber (212) such that a second portion of the second substrate transfer robot extends into the second through hole opening (214) below the second interior bottom face (212B).

## Patentansprüche

1. Substratbehandlungskammervorläufer (200), umfassend:
einen Hauptkörperabschnitt (202), einschließend eine erste Hauptoberfläche (202A), eine zweite Hauptoberfläche (202B) gegenüber der ersten Hauptoberfläche (202A) und mehrere Facetten, die Seitenwände (204A bis 204F) bilden, die sich zwischen der ersten Hauptoberfläche (202A) und der zweiten Hauptoberfläche (202B) erstrecken;
einen sich von der zweiten Hauptoberfläche (202B) und in eine von der ersten Hauptoberfläche (202A) weg verlaufende Richtung erstreckenden Vorsprung (210), wobei der Hauptkörperabschnitt (202) und der Vorsprung (210) als ein einzelnes, einteiliges, geschmiedetes Bauteil gebildet sind;
eine sich von der ersten Hauptoberfläche (202A) nach innen erstreckende erste Ausnehmung (212), die erste Ausnehmung (212) einschließend eine Bodenfläche (212B); und
eine sich von der Bodenfläche (212B) der ersten Ausnehmung (212) durch den Vorsprung (210) erstreckende Durchgangslochöffnung (214);
wobei der Substratbehandlungskammervorläufer (200) bearbeitet werden muss, um daraus eine Substratbehandlungskammer (300, 600) zu bilden, und wobei der Substratbehandlungskammervorläufer (200) dazu konfiguriert ist, bearbeitet zu werden, um daraus Substratbehandlungskammern (300, 600) von wenigstens zwei verschiedenen Typen zu bilden.

2. Substratbehandlungskammervorläufer nach Patentanspruch 1, wobei der Vorsprung (210) eine sich von der zweiten Hauptoberfläche (202B) erstreckende runde, zylindrische Struktur umfasst.

3. Substratbehandlungskammervorläufer nach Patentanspruch 1 oder 2, wobei die erste Ausnehmung (212) einen kreisförmigen Umfang mit einem ersten Durchmesser definiert und die Durchgangslochöffnung (214) einen kreisförmigen Umfang mit einem zweiten Durchmesser definiert, und wobei der zweite Durchmesser weniger als die Hälfte des ersten Durchmessers beträgt.

4. Substratbehandlungskammervorläufer nach einem der Patentansprüche 1 bis 3, wobei die die Seitenwände (204A bis 204F) des Hauptkörperabschnitts (202) bildenden mehreren Facetten eine sechseckige Form bilden.

5. Substratbehandlungskammervorläufer nach Patentanspruch 4, wobei die mehreren Facetten (204A bis 204F) Folgendes einschließen: (a) eine erste Facette (204A), (b) eine sich von der ersten Facette (204A) in einem ersten Winkel erstreckende zweite Facette (204B), (c) eine sich von der ersten Facette (204A) in einem zweiten Winkel erstreckende dritte Facette (204C), (d) eine sich von der zweiten Facette (204B) in einem dritten Winkel erstreckende vierte Facette (204D), (e) eine sich von der dritten Facette (204C) in einem vierten Winkel erstreckende fünfte Facette (204E), und (f) eine sich zwischen der vierten Facette (204D) und der fünften Facette (204E) erstreckende sechste Facette (204F).

6. Substratbehandlungskammervorläufer nach Patentanspruch 5, wobei der zweite Winkel im Wesentlichen gleich dem ersten Winkel und der dritte Winkel im Wesentlichen gleich dem vierten Winkel ist.

7. Substratbehandlungskammervorläufer nach Patentanspruch 6, wobei der dritte Winkel wenigstens 30 Grad größer als der erste Winkel ist.

8. Substratbehandlungskammervorläufer nach Patentanspruch 6 oder 7, wobei sich die sechste Facette (204F) in einem fünften Winkel von der vierten Facette (204D) erstreckt, wobei sich die sechste Facette (204F) in einem sechsten Winkel von der fünften Facette (204E) erstreckt, und wobei der fünfte Winkel im Wesentlichen gleich dem sechsten Winkel ist.

9. Substratbehandlungskammervorläufer nach Patentanspruch 8, wobei der dritte Winkel wenigstens 30 Grad größer als der erste Winkel und wenigstens 30 Grad größer als der fünfte Winkel ist.

10. Substratbehandlungskammervorläufer nach Patentanspruch 5, wobei jede von der ersten Facette (204A) und der sechsten Facette (204F) breiter ist als jede von der zweiten Facette (204B), der dritten Facette (204C), der vierten Facette (204D) und der fünften Facette (204E).

11. Substratbehandlungskammervorläufer nach Patentanspruch 5, wobei jede von der ersten Facette (204A), der zweiten Facette (204B), der dritten Facette (204C) und der sechsten Facette (204F) wenigstens 1,3-mal breiter als jede von der vierten Facette (204D) und der fünften Facette (204E) ist.

12. Verfahren zur Herstellung von Substratbehandlungskammern, umfassend:
Bereitstellen eines ersten Substratbehandlungskammervorläufers (200) nach Patentanspruch 1 und eines zweiten Substratbehandlungskammervorläufers (200) nach Patentanspruch 1, wobei der erste Substratbehandlungskammervorläufer (200) einen ersten Satz von Abmessungen aufweist und der zweite Substratbehandlungskammervorläufer (200) einen zweiten Satz von Abmessungen aufweist, die im Wesentlichen gleich den entsprechenden Abmessungen des ersten Satzes von Abmessungen sind, sodass der erste Substratbehandlungskammervorläufer (200) und der zweite Substratbehandlungskammervorläufer (200) in Größe und Form im Wesentlichen äquivalent sind;
Bearbeiten des ersten Substratbehandlungskammervorläufers (200), um eine erste Materialmenge von dem ersten Substratbehandlungskammervorläufer zu entfernen, um einen ersten Substratbehandlungskammerkörper (300) zu bilden, wobei der erste Substratbehandlungskammerkörper (300) eine erste Außenumfangsform mit einer ersten Anzahl von Facetten (300A bis 300F) einschließt, die sich um den ersten Substratbehandlungskammerkörper (300) herum befinden und dessen erste Seitenwände bilden, aufweist; und
Bearbeiten des zweiten Substratbehandlungskammervorläufers (200), um eine zweite Materialmenge von dem zweiten Substratbehandlungskammervorläufer (200) zu entfernen, um einen zweiten Substratbehandlungskammerkörper (600) zu bilden, wobei der zweite Substratbehandlungskammerkörper (600) eine zweite Außenumfangsform mit einer zweiten Anzahl von Facetten (600A bis 600E) einschließt, die sich um den zweiten Substratbehandlungskammerkörper (600) herum befinden und dessen zweite Seitenwände bilden, wobei die zweite Anzahl von Facetten (600A bis 600E) kleiner als die erste Anzahl von Facetten (300A bis 300F) ist, und wobei die zweite Materialmenge größer als die erste Materialmenge ist.

13. Verfahren nach Patentanspruch 12, wobei die erste Ausnehmung (212) einen kreisförmigen Umfang mit einem ersten Durchmesser definiert und die Durchgangslochöffnung (214) einen kreisförmigen Umfang mit einem zweiten Durchmesser definiert, und wobei der zweite Durchmesser weniger als die Hälfte des ersten Durchmessers beträgt.

14. Verfahren nach Patentanspruch 12, wobei der Vorsprung jedes von dem ersten Substratbehandlungskammervorläufer (200) und dem zweiten Substratbehandlungskammervorläufer (200) eine sich von der zweiten Hauptoberfläche (202B) erstreckende runde, zylindrische Struktur umfasst.

15. Verfahren nach einem der Patentansprüche 12 bis 14, wobei die erste Anzahl von die ersten Seitenwände des ersten Substratbehandlungskammerkörpers (300) bildenden Facetten (300A bis 300F) wenigstens sechs Facetten (300A bis 300F) umfasst, und wobei die zweite Anzahl von die zweiten Seitenwände des zweiten Substratbehandlungskammerkörpers (600) bildenden Facetten (600A bis 600E) nicht mehr als fünf Facetten (600A bis 600E) umfasst.

16. Verfahren nach einem der Patentansprüche 12 bis 14, wobei jeder von dem ersten Substratbehandlungskammervorläufer (200) und dem zweiten Substratbehandlungskammervorläufer (200) Folgendes einschließt: (a) eine erste Facette (204A), (b) eine sich von der ersten Facette (204A) in einem ersten Winkel erstreckende zweite Facette (204B), (c) eine sich von der ersten Facette (204A) in einem zweiten Winkel erstreckende dritte Facette (204C), (d) eine sich von der zweiten Facette (204B) in einem dritten Winkel erstreckende vierte Facette (204D), (e) eine sich von der dritten Facette (204C) in einem vierten Winkel erstreckende fünfte Facette (204E), und (f) eine sich zwischen der vierten Facette (204D) und der fünften Facette (204E) erstreckende sechste Facette (204F).

17. Verfahren nach Patentanspruch 16, wobei der zweite Winkel im Wesentlichen gleich dem ersten Winkel und der dritte Winkel im Wesentlichen gleich dem vierten Winkel ist.

18. Verfahren nach Patentanspruch 17, wobei sich die sechste Facette (204F) in einem fünften Winkel von der vierten Facette (204D) erstreckt, wobei sich die sechste Facette (204F) in einem sechsten Winkel von der fünften Facette (204E) erstreckt, und wobei der fünfte Winkel im Wesentlichen gleich dem sechsten Winkel ist.

19. Verfahren nach Patentanspruch 18, wobei der dritte Winkel wenigstens 30 Grad größer als der erste Winkel und/oder wenigstens 30 Grad größer als der fünfte Winkel ist.

20. Verfahren nach Patentanspruch 16, wobei jede von der ersten Facette (204A) und der sechsten Facette (204F) breiter als jede von der zweiten Facette (204B), der dritten Facette (204C), der vierten Facette (204D) und der fünften Facette (204E) ist.

21. Verfahren nach Patentanspruch 16, wobei jede von der ersten Facette (204A), der zweiten Facette (204B), der dritten Facette (204C) und der sechsten Facette (204F) wenigstens 1,3-mal breiter als jede von der vierten Facette (204D) und der fünften Facette (204E) ist.

22. Verfahren nach einem der Patentansprüche 12 bis 21, wobei der erste Substratbehandlungskammervorläufer (200) und der zweite Substratbehandlungskammervorläufer (200) als Teil eines Bestands von Vorläufern (200) bereitgestellt werden, die zum Bilden mehrerer Substratbehandlungskammerkörper (300, 600) bereitgestellt sind, wobei jeder Vorläufer (200) des Bestands einen Satz von Abmessungen einschließt, die im Wesentlichen gleich entsprechenden Abmessungen des ersten Satzes von Abmessungen sind, sodass alle Vorläufer (200) im Bestand im Wesentlichen äquivalente Größen und Formen aufweisen.

23. Verfahren nach einem der Patentansprüche 12 bis 22, wobei der erste Substratbehandlungskammerkörper (300) so gebildet ist, dass er Folgendes einschließt: (a) eine erste Oberseite (430S), (b) eine gegenüber der ersten Oberseite befindliche erste Unterseite und (c) eine sich von der ersten Oberseite (430S) nach innen erstreckende erste Kammer, und wobei das Verfahren ferner Folgendes umfasst: Herstellen eines Eingriffs eines ersten Deckels (430) mit dem ersten Substratbehandlungskammerkörper (600), wobei der erste Deckel (430) so dimensioniert, geformt und bewegbar positionierbar ist, dass er eine erste Öffnung (212A) zur ersten Kammer an der ersten Oberseite (430S) abdeckt; und/oder
wobei der zweite Substratbehandlungskammerkörper (600) so gebildet ist, dass er Folgendes einschließt: (a) eine zweite Oberseite (430S), (b) eine gegenüber der zweiten Oberseite befindliche zweite Unterseite und (c) eine sich von der zweiten Oberseite (430S) nach innen erstreckende zweite Kammer, und wobei das Verfahren ferner Folgendes umfasst: Herstellen eines Eingriffs eines zweiten Deckels (430) mit dem zweiten Substratbehandlungskammerkörper (600), wobei der zweite Deckel (430) so dimensioniert, geformt und bewegbar positionierbar ist, dass er eine zweite Öffnung (212A) zur zweiten Kammer an der zweiten Oberseite (430S) abdeckt.

24. Verfahren nach einem der Patentansprüche 12 bis 22, wobei der erste Substratbehandlungskammerkörper (300) so gebildet ist, dass er Folgendes einschließt: (a) eine erste Oberseite (430S), (b) eine gegenüber der ersten Oberseite befindliche erste Unterseite, (c) eine sich von der ersten Oberseite (430S) zu einer ersten inneren unteren Fläche (212B) nach innen erstreckende erste Kammer (212), und (d) eine sich von der ersten inneren unteren Fläche (212B) zur ersten Unterseite erstreckende erste Durchgangslochöffnung (214), wobei das Verfahren ferner Folgendes umfasst: Platzieren eines ersten Substrattransferroboters in der ersten Kammer (212), sodass sich ein erster Abschnitt des ersten Substrattransferroboters in die erste Durchgangslochöffnung (214) unterhalb der ersten inneren unteren Fläche (214B) erstreckt; und/oder
wobei der zweite Substratbehandlungskammerkörper (600) so gebildet ist, dass er Folgendes einschließt: (a) eine zweite Oberseite (430S), (b) eine gegenüber der zweiten Oberseite befindliche zweite Unterseite, (c) eine sich von der zweiten Oberseite (430S) nach innen zu einer zweiten inneren unteren Fläche (212B) erstreckende zweite Kammer (212), und (d) eine sich von der zweiten inneren unteren Fläche (212B) zu der zweiten Unterseite erstreckende zweite Durchgangslochöffnung (214), und wobei das Verfahren ferner Folgendes umfasst: Platzieren eines zweiten Substratübertragungsroboters in der zweiten Kammer (212), sodass sich ein zweiter Abschnitt des zweiten Substratübertragungsroboters in die zweite Durchgangslochöffnung (214) unter der zweiten inneren unteren Fläche (212B) erstreckt.

## Revendications

1. Précurseur de chambre de manipulation de substrat (200), comprenant :
une partie de corps principale (202) comportant une première grande surface (202A), une deuxième grande surface (202B) opposée à la première grande surface (202A) et de multiples facettes formant des parois latérales (204A à 204F) s'étendant entre la première grande surface (202A) et la deuxième grande surface (202B) ;
une saillie (210) s'étendant depuis la deuxième grande surface (202B) dans une direction s'éloignant de la première grande surface (202A), dans lequel la partie de corps principale (202) et la saillie (210) sont formées en une seule pièce de composant forgée en monobloc ;
un premier évidement (212) s'étendant vers l'intérieur depuis la première grande surface (202A), le premier évidement (212) comportant une surface de dessous (212B) ; et
une ouverture de trou traversant (214) s'étendant depuis la surface de dessous (212B) du premier évidement (212) à travers la saillie (210) ;
dans lequel le précurseur de chambre de manipulation de substrat (200) doit être usiné pour former à partir de celui-ci une chambre de manipulation de substrat (300, 600), et dans lequel le précurseur de chambre de manipulation de substrat (200) est configuré pour être usiné de manière à former à partir de celui-ci des chambres de manipulation de substrats (300, 600) d'au moins deux types différents.

2. Précurseur de chambre de manipulation de substrat selon la revendication 1, dans lequel la saillie (210) comprend une structure cylindrique ronde s'étendant depuis la deuxième grande surface (202B).

3. Précurseur de chambre de manipulation de substrat selon la revendication 1 ou 2, dans lequel le premier évidement (212) définit un périmètre circulaire ayant un premier diamètre, et l'ouverture de trou traversant (214) définit un périmètre circulaire ayant un deuxième diamètre, et dans lequel le deuxième diamètre est inférieur à la moitié du premier diamètre.

4. Précurseur de chambre de manipulation de substrat selon l'une quelconque des revendications 1 à 3, dans lequel les multiples facettes formant les parois latérales (204A à 204F) de la partie de corps principale (202) forment une forme hexagonale.

5. Précurseur de chambre de manipulation de substrat selon la revendication 4, dans lequel les multiples facettes (204A à 204F) comportent : (a) une première facette (204A), (b) une deuxième facette (204B) s'étendant depuis la première facette (204A) selon un premier angle, (c) une troisième facette (204C) s'étendant depuis la première facette (204A) selon un deuxième angle, (d) une quatrième facette (204D) s'étendant depuis la deuxième facette (204B) selon un troisième angle, (e) une cinquième facette (204E) s'étendant depuis la troisième facette (204C) selon un quatrième angle et (f) une sixième facette (204F) s'étendant entre la quatrième facette (204D) et la cinquième facette (204E).

6. Précurseur de chambre de manipulation de substrat selon la revendication 5, dans lequel le deuxième angle est sensiblement égal au premier angle, et le troisième angle est sensiblement égal au quatrième angle.

7. Précurseur de chambre de manipulation de substrat selon la revendication 6, dans lequel le troisième angle est supérieur d'au moins 30 degrés au premier angle.

8. Précurseur de chambre de manipulation de substrat selon la revendication 6 ou 7, dans lequel la sixième facette (204F) s'étend depuis la quatrième facette (204D) selon un cinquième angle, dans lequel la sixième facette (204F) s'étend depuis la cinquième facette (204E) selon un sixième angle, et dans lequel le cinquième angle est sensiblement égal au sixième angle.

9. Précurseur de chambre de manipulation de substrat selon la revendication 8, dans lequel le troisième angle est supérieur d'au moins 30 degrés au premier angle et supérieur d'au moins 30 degrés au cinquième angle.

10. Précurseur de chambre de manipulation de substrat selon la revendication 5, dans lequel chacune parmi la première facette (204A) et la sixième facette (204F) est plus large que chacune parmi la deuxième facette (204B), la troisième facette (204C), la quatrième facette (204D) et la cinquième facette (204E).

11. Précurseur de chambre de manipulation de substrat selon la revendication 5, dans lequel chacune parmi la première facette (204A), la deuxième facette (204B), la troisième facette (204C) et la sixième facette (204F) est au moins 1,3 fois plus large que chacune parmi la quatrième facette (204D) et la cinquième facette (204E).

12. Procédé de fabrication de chambres de manipulation de substrats, comprenant les étapes suivantes :
fournir un premier précurseur de chambre de manipulation de substrat (200) tel que défini dans la revendication 1 et un deuxième précurseur de chambre de manipulation de substrat (200) tel que défini dans la revendication 1, le premier précurseur de chambre de manipulation de substrat (200) ayant un premier ensemble de dimensions et le deuxième précurseur de chambre de manipulation de substrat (200) ayant un deuxième ensemble de dimensions qui sont sensiblement égales aux dimensions correspondantes du premier ensemble de dimensions, de sorte que le premier précurseur de chambre de manipulation de substrat (200) et le deuxième précurseur de chambre de manipulation de substrat (200) soient sensiblement équivalents en taille et en forme ;
usiner le premier précurseur de chambre de manipulation de substrat (200) pour retirer une première quantité de matériau du premier précurseur de chambre de manipulation de substrat afin de former un premier corps de chambre de manipulation de substrat (300), dans lequel le premier corps de chambre de manipulation de substrat (300) comporte une première forme de périmètre extérieur autour de laquelle est situé un premier nombre de facettes (300A à 300F) formant des premières parois latérales du premier corps de chambre de manipulation de substrat (300) ; et
usiner le deuxième précurseur de chambre de manipulation de substrat (200) pour retirer une deuxième quantité de matériau du deuxième précurseur de chambre de manipulation de substrat (200) afin de former un deuxième corps de chambre de manipulation de substrat (600), dans lequel le deuxième corps de chambre de manipulation de substrat (600) comporte une deuxième forme de périmètre extérieur autour de laquelle est situé un deuxième nombre de facettes (600A à 600E) formant des deuxièmes parois latérales du deuxième corps de chambre de manipulation de substrat (600), dans lequel le deuxième nombre de facettes (600A à 600E) est inférieur au premier nombre de facettes (300A à 300F), et dans lequel la deuxième quantité de matériau est supérieure à la première quantité de matériau.

13. Procédé selon la revendication 12,
dans lequel le premier évidement (212) définit un périmètre circulaire ayant un premier diamètre, et l'ouverture de trou traversant (214) définit un périmètre circulaire ayant un deuxième diamètre, et dans lequel le deuxième diamètre est inférieur à la moitié du premier diamètre.

14. Procédé selon la revendication 12,
dans lequel la saillie de chacun parmi le premier précurseur de chambre de manipulation de substrat (200) et le deuxième précurseur de chambre de manipulation de substrat (200) comprend une structure cylindrique ronde s'étendant depuis la deuxième grande surface (202B).

15. Procédé selon l'une quelconque des revendications 12 à 14,
dans lequel le premier nombre de facettes (300A à 300F) formant les premières parois latérales du premier corps de chambre de manipulation de substrat (300) comprend au moins six facettes (300A à 300F), et dans lequel le deuxième nombre de facettes (600A à 600E) formant les deuxièmes parois latérales du deuxième corps de chambre de manipulation de substrat (600) comprend au plus cinq facettes (600A à 600E).

16. Procédé selon l'une quelconque des revendications 12 à 14,
dans lequel chacun parmi le premier précurseur de chambre de manipulation de substrat (200) et le deuxième précurseur de chambre de manipulation de substrat (200) comporte : (a) une première facette (204A), (b) une deuxième facette (204B) s'étendant depuis la première facette (204A) selon un premier angle, (c) une troisième facette (204C) s'étendant depuis la première facette (204A) selon un deuxième angle, (d) une quatrième facette (204D) s'étendant depuis la deuxième facette (204B) selon un troisième angle, (e) une cinquième facette (204E) s'étendant depuis la troisième facette (204C) selon un quatrième angle et (f) une sixième facette (204F) s'étendant entre la quatrième facette (204D) et la cinquième facette (204E).

17. Procédé selon la revendication 16,
dans lequel le deuxième angle est sensiblement égal au premier angle, et le troisième angle est sensiblement égal au quatrième angle.

18. Procédé selon la revendication 17,
dans lequel la sixième facette (204F) s'étend depuis la quatrième facette (204D) selon un cinquième angle, dans lequel la sixième facette (204F) s'étend depuis la cinquième facette (204E) selon un sixième angle, et dans lequel le cinquième angle est sensiblement égal au sixième angle.

19. Procédé selon la revendication 18,
dans lequel le troisième angle est supérieur d'au moins 30 degrés au premier angle et/ou supérieur d'au moins 30 degrés au cinquième angle.

20. Procédé selon la revendication 16,
dans lequel chacune parmi la première facette (204A) et la sixième facette (204F) est plus large que chacune parmi la deuxième facette (204B), la troisième facette (204C), la quatrième facette (204D) et la cinquième facette (204E).

21. Procédé selon la revendication 16,
dans lequel chacune parmi la première facette (204A), la deuxième facette (204B), la troisième facette (204C) et la sixième facette (204F) est au moins 1,3 fois plus large que chacune parmi la quatrième facette (204D) et la cinquième facette (204E).

22. Procédé selon l'une quelconque des revendications 12 à 21,
dans lequel le premier précurseur de chambre de manipulation de substrat (200) et le deuxième précurseur de chambre de manipulation de substrat (200) font partie d'un inventaire de précurseurs (200) prévus pour former de multiples corps de chambre de manipulation de substrat (300, 600), dans lequel chaque précurseur (200) de l'inventaire comporte un ensemble de dimensions qui sont sensiblement égales aux dimensions correspondantes du premier ensemble de dimensions, de sorte que tous les précurseurs (200) de l'inventaire aient des tailles et des formes sensiblement équivalentes.

23. Procédé selon l'une quelconque des revendications 12 à 22, dans lequel le premier corps de chambre de manipulation de substrat (300) est formé de manière à comporter : (a) une première surface de dessus (430S), (b) une première surface de dessous située opposée à la première surface de dessus et (c) une première chambre s'étendant vers l'intérieur depuis la première surface de dessus (430S), et dans lequel le procédé comprend en outre : la mise en prise d'un premier couvercle (430) avec le premier corps de chambre de manipulation de substrat (600), dans lequel le premier couvercle (430) est dimensionné, formé et positionnable de manière mobile pour recouvrir une première ouverture (212A) sur la première chambre au niveau de la première surface de dessus (430S) ; et/ou
dans lequel le deuxième corps de chambre de manipulation de substrat (600) est formé de manière à comporter : (a) une deuxième surface de dessus (430S), (b) une deuxième surface de dessous située opposée à la deuxième surface de dessus et (c) une deuxième chambre s'étendant vers l'intérieur depuis la deuxième surface de dessus (430S), et dans lequel le procédé comprend en outre : la mise en prise d'un deuxième couvercle (430) avec le deuxième corps de chambre de manipulation de substrat (600), dans lequel le deuxième couvercle (430) est dimensionné, formé et positionnable de manière mobile pour recouvrir une deuxième ouverture (212A) dans la deuxième chambre au niveau de la deuxième surface de dessus (430S).

24. Procédé selon l'une quelconque des revendications 12 à 22,
dans lequel le premier corps de chambre de manipulation de substrat (300) est formé de manière à comporter : (a) une première surface de dessus (430S), (b) une première surface de dessous située opposée à la première surface de dessus, (c) une première chambre (212) s'étendant vers l'intérieur depuis la première surface de dessus (430S) jusqu'à une première face de dessous intérieure (212B) et (d) une première ouverture de trou traversant (214) s'étendant depuis la première face de dessous intérieure (212B) jusqu'à la première surface de dessous, et dans lequel le procédé comprend en outre : le placement d'un premier robot de transfert de substrat dans la première chambre (212) de sorte qu'une première partie du premier robot de transfert de substrat s'étende dans la première ouverture de trou traversant (214) en dessous de la première face de dessous intérieure (214B) ; et/ou
dans lequel le deuxième corps de chambre de manipulation de substrat (600) est formé de manière à comporter : (a) une deuxième surface de dessus (430S), (b) une deuxième surface de dessous située opposée à la deuxième surface de dessus, (c) une deuxième chambre s'étendant (212) vers l'intérieur depuis la deuxième surface de dessus (430S) jusqu'à une deuxième face de dessous intérieure (212B) et (d) une deuxième ouverture de trou traversant (214) s'étendant depuis la deuxième face de dessous intérieure (212B) jusqu'à la deuxième surface de dessous, et dans lequel le procédé comprend en outre : le placement d'un deuxième robot de transfert de substrat dans la deuxième chambre (212) de sorte qu'une deuxième partie du deuxième robot de transfert de substrat s'étende dans la deuxième ouverture de trou traversant (214) en dessous de la deuxième face de dessous intérieure (212B).
